(19) Europäisches Patentamt
European Patent Office
Office européen des brevets

(11) **EP 2 139 120 B1**

(12) **EUROPÄISCHE PATENTSCHRIFT**

(45) Veröffentlichungstag und Bekanntmachung des Hinweises auf die Patenterteilung:
**23.01.2019 Patentblatt 2019/04**

(51) Int Cl.:
*H03M 13/27* (2006.01)    *H03M 13/29* (2006.01)

(21) Anmeldenummer: **09008223.1**

(22) Anmeldetag: **23.06.2009**

(54) **Interleaver**

Interleaver

Dispositif d'entrelacement

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **23.06.2008 DE 102008029623**
**23.06.2008 US 144257**

(43) Veröffentlichungstag der Anmeldung:
**30.12.2009 Patentblatt 2009/53**

(73) Patentinhaber: **Fraunhofer-Gesellschaft zur Förderung der angewandten Forschung e.V.**
**80686 München (DE)**

(72) Erfinder: **Breiling, Marco**
**91052 Erlangen (DE)**

(74) Vertreter: **Schenk, Markus et al**
**Schoppe, Zimmermann, Stöckeler Zinkler, Schenk & Partner mbB**
**Patentanwälte**
**Radlkoferstrasse 2**
**81373 München (DE)**

(56) Entgegenhaltungen:
**EP-A2- 1 030 455        EP-A2- 1 418 675**
**US-A1- 2005 102 599**

• AKIRA SHIBUTANI ET AL: "Multistage Recursive Interleaver for Turbo Codes in DS-CDMA Mobile Radio", IEEE TRANSACTIONS ON VEHICULAR TECHNOLOGY, IEEE SERVICE CENTER, PISCATAWAY, NJ, US, Bd. 51, Nr. 1, 1. Januar 2002 (2002-01-01) , XP011064354, ISSN: 0018-9545

**Beschreibung**

Die vorliegende Erfindung bezieht sich auf Interleaver, wie sie beispielsweise im Bereich der Informations- und Kodierungstechnik zur Verwürflung von Informationen eingesetzt werden.

Im Bereich der konventionellen Technik kommen Interleaver beispielsweise bei der Datenübertragung zum Einsatz. Oftmals werden dort Binärstellen in Form von Sendesymbolen übertragen, die dann bei der Übertragung, z.B. über einen Mobilfunkkanal, gestört werden. Da von einer Störung zumeist mehrere aufeinanderfolgende Symbole betroffen sind, man spricht auch von sog. Bündelfehlern, kommen Verwürfelungstechniken zum Einsatz. Dies bedeutet, dass in einem ursprünglichen Informationswort einzelne Stellen derart verwürfelt werden, dass diese bei der Übertragung nicht mehr aufeinanderfolgend sind. Dies hat zur Folge, dass beim Auftreten von Bündelfehlern, und anschließendem Rückverwürfeln, die Bündelfehler auseinander gerissen werden, und sich so über das Informationswort verteilen. Diese Technologien kommen beispielsweise auch bei der Speicherung von Daten, z.B. bei Audio-CDs zum Einsatz. Idealerweise werden die auftretenden Bündelfehler auseinander gerissen und führen so zu Einzelfehlern, die korrigierbar sind. Zum Verwürfeln, bzw. Rückwürfeln kommen sog. Interleaver zum Einsatz.

In der Nachrichtentechnik werden zum Schutz vor Übertragungsfehlern Fehler korrigierende Kodes eingesetzt. Beispielsweise kommen hier Faltungskodierer, Blockkodierer, usw. zum Einsatz. Turbo Kodes sind dabei eine der leistungsstärksten Kode-Klassen und ihre Fähigkeit Übertragungsfehler zu korrigieren überragt die von Faltungskodes bei weitem, vgl. z.B. Claude Berrou, Alain Glavieux, and Punya Thitimajshima: "Near Shannon-Limit Error-Correcting Coding and Decoding: Turbo Codes", Intern. Conf. on Communication, pages 1064-1070, 1993.

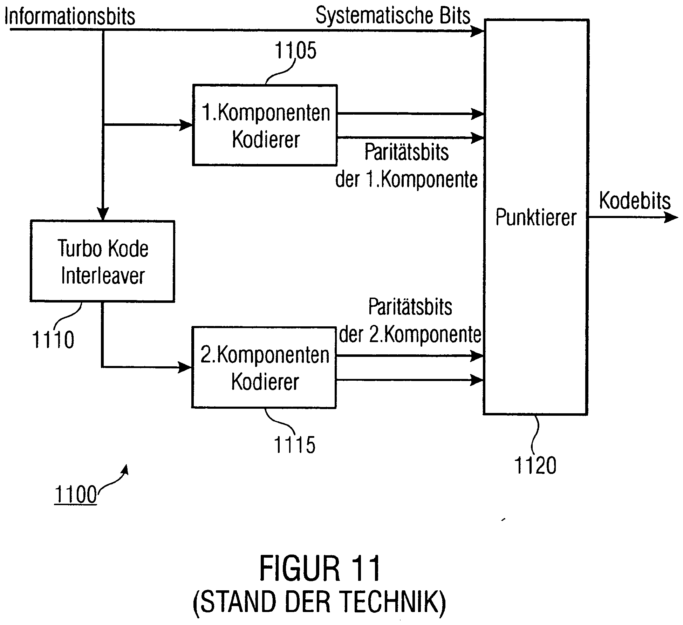

Turbo Kode Interleaver sind ein integraler Bestandteil von Turbo-Kodierern, sowie der zugehörigen Turbo-Dekodierer. Die Fig. 11 illustriert ein prinzipielles Blockschaltbild eines solchen Turbo Kodierers 1100. Der Turbo Kodierer 1100 weist dabei einen 1. Komponentenkodierer 1105, einen Turbo Kode Interleaver 1110, einen 2. Komponentenkodierer 1115 und einen Punktierer 1120 auf. Ein Informationswort, d.h. ein Vektor bestehend aus Informationsbits, die beispielsweise durch einen Indexbereich von 0 bis Infoword_Len-1 spezifiziert werden können, wobei Infoword_Len der Wortlänge entspricht, wird enkodiert, indem eine 1. Kopie unmittelbar dem Punktierer 1120, eine 2. Kopie des Vektors dem 1. Komponentenkodierer 1105 und eine 3. Kopie dem Turbo Kode Interleaver 1110 zugeführt wird. Der Turbo Kode Interleaver 1110 permutiert die Bits dieses Sektors, d.h. er sortiert diese Bits oder Stellen um, ändert deren Reihenfolge und gibt den so permutierten Vektor der gleichen Länge Infoword_Len an den 2. Komponentenkodierer 1115 weiter.

Beide Komponentenkodierer 1105 und 1115 sind üblicherweise gleich und stellen einen rekursiven Faltungskodierer dar, der pro Eingangsbit mindestens ein Paritätsbit, ggf. auch mehrere, an seinem Ausgang bzw. seinen Ausgängen zur Verfügung stellt. In der Fig. 11 sind jeweils zwei Paritätsbits für die beiden Komponentenkodierer 1105 und 1115 gezeigt.

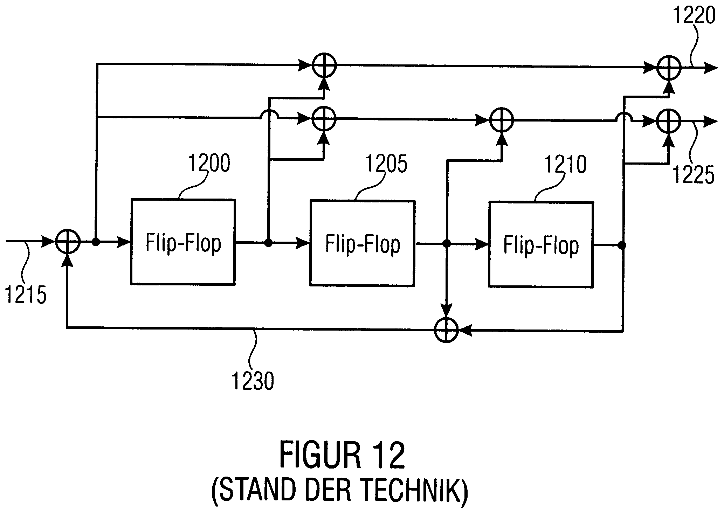

Die Fig. 12 zeigt ein Beispiel eines Komponentenkodierers, der beispielsweise als Faltungskodierer realisiert sein kann. Die Fig. 12 zeigt ein Beispiel eines rekursiven Faltungskodierers mit 2 Paritätsbits pro Eingangsbit und einer Gedächtnislänge von 3. Die Fig. 12 zeigt 3 Flip-Flops 1200, 1205 und 1210, die über Summationsglieder und Kopplungszweige miteinander verknüpft sind. Das in der Fig. 12 dargestellte Beispiel zeigt, dass für ein Eingangsbit, das am Eingang 1215 anliegt, jeweils 2 Paritätsbits an den Ausgängen 1220 und 1225 ausgegeben werden. Ferner entsprechen die 3 Flip-Flops 1200, 1205 und 1210 3 Ein-Bit-Speichern, die die Gedächtnislänge von 3 realisieren. Jedes der 3 Flip-Flops 1200, 1205 und 1210 speichert ein Bit, d.h. Binär "0" oder "1", für eine Zeiteinheit und gibt dieses an dem jeweiligen Ausgang aus. Zu Beginn der nächsten Zeiteinheit wird das am Eingang eines Flip-Flops anliegende Bit gespeichert und dann ausgegeben. Somit kann die Anordnung in der Fig. 12 auch als übliches Schieberegister betrachtet werden. Die Plussymbole markieren die Summationsglieder, also diejenigen Knoten, an denen binär addiert wird, wobei die binäre Addition der binären Exklusiv-Oder-Verknüpfung entspricht. Im unteren Teil der Fig. 12 lässt sich ein Rückkopplungszweig 1230 erkennen, wodurch der Inhalt des Schieberegisters auf seinen Eingang 1215 zurückgekoppelt wird. Die Fig. 12 zeigt somit ein Beispiel eines Faltungskodierers, der in der Darstellung der Fig. 11 als Komponentenkodierer zum Einsatz kommen kann.

Gemäß dem Beispiel der Fig. 11 werden die Paritätsbits der Komponentenkodierer 1105 und 1115, die systematischen Bits, die den Informationsbits entsprechen einem Punktierer 1120 zur Verfügung gestellt. Aus der Fig. 11 lässt sich erkennen, dass der Punktierer 1120 5 Eingänge und nur einen Ausgang hat. In dem Punktierer 1120 findet eine Parallel-Seriell-Wandlung der 5 Eingänge auf den einen Ausgang statt, wobei aber auch Bits, die an den Eingängen anliegen, einfach verworfen und nicht zum Ausgang weitergegeben werden können. Dies kann beispielsweise über ein Punktierungsmuster gesteuert werden, welches festlegt, welche Bits der 5 Eingänge an den Ausgang weitergereicht werden. Zum Beispiel kann der Punktierer jedes systematische Bit, aber nur jedes 2. Bit der 4 Paritätsbit-Eingänge zum Ausgang weiterleiten. Da für jedes zu übertragende Informationswort an jedem der 5 Eingänge insgesamt Infoword_Len Bits anliegen, können maximal 5×Infoword_Len Bits ausgegeben werden.

Durch ein geeignetes Punktierungsmuster kann erreicht werden, dass eine eingestellte Menge von Codeword_Len Bits vom Punktierer ausgegeben wird, so dass die Länge eines ausgegebenen Kodewortes, das sich aus den Kodebits zusammensetzt, Codeword_Len ist. Das Verhältnis aus Infoword_Len/Codeword_Len ist die Kode-Rate des Turbo Kodes. Für obiges Beispiel kann die Kode-Rate durch den Punktierer zwischen 1/5 und 1 eingestellt werden.

Nach der Übertragung der Kodebits, d.h. des Kodewortes, über einen Übertragungskanal werden beispielsweise im Empfänger gestörte Bits verarbeitet, die dort in Form von Soft-Bits vorliegen können. In anderen Worten können Binärstellen im Empfänger höher aufgelöst dargestellt werden, d.h. für eine gesendete Binärstelle "0" oder "1", können in einem Empfänger mehrere Binärstellen benutzt werden. Beispielsweise können so Zuverlässigkeitsinformationen der einzelnen Binärstellen mit bei der Dekodierung berücksichtigt werden. Ein Turbo Dekoder hat nun die Aufgabe Übertragungsfehler zu korrigieren.

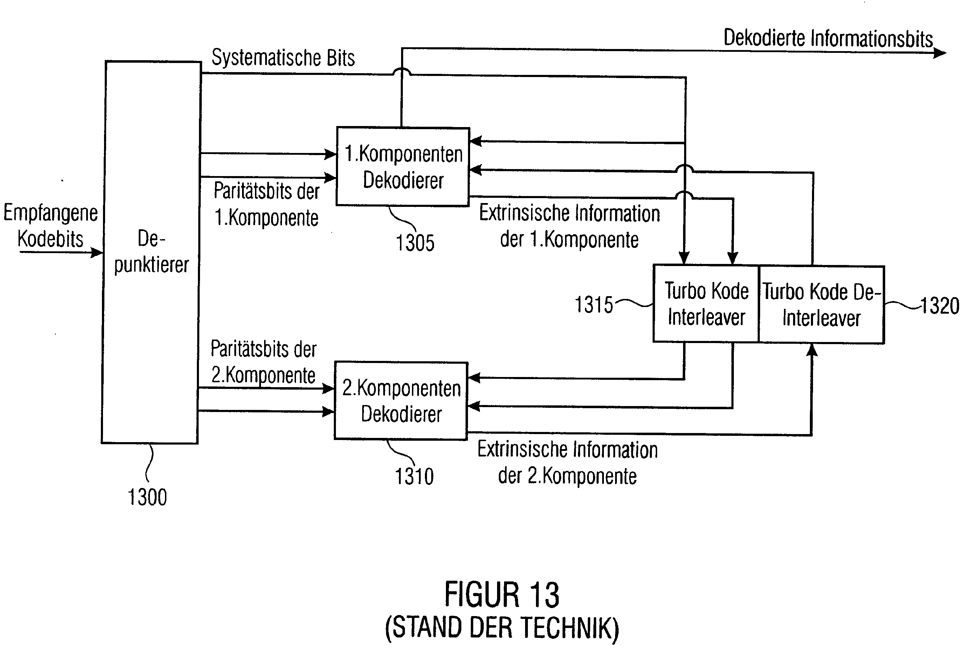

Ein dem in der Fig. 11 gezeigten Turbo Kodierer angepasster Turbo Dekodierer ist in der Fig. 13 gezeigt. Der Turbo Dekodierer umfasst einen Depunktierer 1300, einen 1. Komponentendekodierer 1305, einen 2. Komponenten-Dekodierer 1310, einen Turbo Kode Interleaver 1315 und einen Turbo Kode De-Interleaver 1320. Bereits aus der Struktur des in der Fig. 13 gezeigten Turbo Dekodierers lässt sich erkennen, dass der Turbo Kode Interleaver 1315 und der Turbo Kode De-Interleaver 1320 eine zentrale Rolle spielen.

Ein Turbo Dekoder arbeitet iterativ, d.h. im Gegensatz zu Viterbi-Dekodern für Faltungskodes wird hier jeder Komponentendekoder nicht nur einmal verwendet, sondern einmal pro Iteration, wobei mehrere Iterationen durchgeführt werden können, typischerweise liegt die Anzahl der Iterationen bei 3 bis 8. Der Depunktierer 1300 bestimmt aus den empfangenen Kode-Bits die systematischen Bits, sowie die Paritätsbits der 1. Komponente und der 2. Komponente. Die Paritätsbits der 1. Komponente werden dem 1. Komponentendekodierer 1305, die Paritätsbits der 2. Komponente dem 2. Komponentendekodierer 1310 zugeführt. In jeder Iteration berechnet der 1. Komponentendekodierer 1305 auf der Basis seiner Eingänge, d.h. auf Basis der Paritätsbits der 1. Komponente, der systematischen Bits, sowie der extrinsischen Information der 2. Komponente ein Ausgangssignal, welches als extrinsische Information der 1. Komponente bezeichnet werden kann.

Für jedes der Infoword_Len systematischen Bits existiert auch eine extrinsische Information, d.h. dieser Ausgang des 1. Komponentendekodierers 1305 ist ein Vektor von Infoword Len extrinsischen Informationen. Außerdem liefert der 1. Komponentendekodierer 1305 über einen 2. Ausgang einen Vektor von Infoword_Len dekodierten, d.h. geschätzten Informationsbits. Die beiden Vektoren der systematischen Soft-Bits und der extrinsischen Information der 1. Komponente werden im Turbo Kode Interleaver 1315 permutiert, d.h. jeder Vektor wird getrennt für sich und mit derselben Permutation wie im Turbo-Enkoder verwürfelt, wie beispielsweise in der Fig. 11 dargestellt.

Ebenso berechnet der 2. Komponentendekodierer 1310 basierend auf seinen Eingängen als Ausgang einen Vektor der Länge Infoword_Len von extrinsischen Informationen der 2. Komponente. Diese wird über den Turbo Kode De-Interleaver 1320 zurück zum 1. Komponentendekodierer 1305 geführt, so dass dieser die nächste Iteration beginnen kann. Während der Iterationen tauschen der 1. und der 2. Komponentendekodierer 1305; 1310 ihre jeweiligen extrinsischen Informationen über den Turbo Kode Interleaver 1315 bzw. den Turbo Kode De-Interleaver 1320 aus. Der Turbo Kode De-Interleaver 1320 passt dabei derart zu dem Turbo Kode Interleaver 1315, dass ein Vektor der Länge Infoword_Len, der einmal mit dem Turbo Kode Interleaver 1315 permutiert und das Ergebnis hernach mit dem Turbo Kode De-Interleaver 1320 permutiert wurde, wieder identisch zu dem ursprünglichen Vektor ist.

Der Turbo Kode Interleaver 1315 hat u.a. die Aufgabe, hohe Distanzen zwischen den permutierten Kodewörtern sicherzustellen. Als Maß kann im Allgemeinen die Hamming-Distanz zwischen Kodewörtern verwendet werden, die der Anzahl von Bits entspricht, in denen sich 2 Kodewörter A und B unterscheiden. Wird Kodewort A übertragen, so wird stattdessen fälschlicherweise das Kodewort B vom Empfänger ausgewählt, wenn diese Bits vom Kanal verfälscht wurden. Tatsächlich reicht es aus, wenn mehr als die Hälfte dieser Bits verfälscht wurden. Naturgemäß wird die Wahrscheinlichkeit, dass ein falsches Kodewort B ausgewählt wird umso geringer, je größer die Hamming-Distanz zwischen A und B ist, vgl. z.B. Todd K. Moon "Error Correction Coding", Wiley, 2007, ISBN 978-0-471-64800-0.

Der Turbo Kode Interleaver 1100 bzw. 1315 soll nun dafür sorgen, dass die Distanzen zwischen jedem möglichen Kodewort A und allen anderen möglichen Kodewörtern B groß werden. Die Lösung dieser Aufgabe lässt sich wie folgt etwas vereinfachen. Die Hamming-Distanz zwischen 2 Kodewörtern A und B lässt sich berechnen als das Hamming-Gewicht des Vektors A plus B, wobei das Gewicht die Anzahl von Einsen des Vektors meint. Hierbei repräsentiert, wie bereits oben erläutert, das Plus-Symbol eine binäre Addition, was einer Ex-Or-Verknüpfung (Exklusiv-Oder-Verknüpfung) zwischen je einem Bit von A und B entspricht, d.h. Bit 0 von A wird mit Bit 0 von B verknüpft, Bit 1 von A wird mit Bit 1 von B verknüpft, Bit 2 von A wird mit Bit 2 von B verknüpft, usw.

Turbo Kodes sind linear, d.h. sie besitzen die Eigenschaft, dass A plus B ein gültiges Kodewort ist, wenn A und B gültige Kodewörter sind. Daher darf als Kodewort A auch der Null-Vektor als übertragenes Kodewort angenommen werden. Die Distanzen zu allen anderen Kodewörtern B sind dann einfach die Hamming-Gewichte dieser anderen Kodewörter. Auf Grund der Linearitätseigenschaft ist die Distanzverteilung, d.h. das Histogramm der vorkommenden Distanzen zu allen möglichen Kodewörtern B, identisch für jedes Kodewort A, also auch für den Null-Vektor. Wird dieser als Kodewort A angenommen, wird die Distanzverteilung identisch zur Gewichtsverteilung aller möglichen Kodewörter.

Gemäß den obigen Erläuterungen, gibt ein Turbo-Kodierer, wie beispielsweise in der Fig. 11 dargestellt, an seinem Ausgang einen Null-Vektor aus, wenn sein Eingang ein 0-Vektor ist. Auf Grund der obigen Überlegungen ist es demnach Ziel des Turbo Kode Interleavers 1110;1315 dafür zu sorgen, dass am Ausgang ein möglichst großes Gewicht entsteht, wenn am Eingang ein anderer Vektor als der Null-Vektor anliegt.

Insbesondere das minimale Gewicht $d_{min}$ aller Kodewörter ist wichtig, denn bei einer Übertragung des Nullwortes ist eine Verfälschung zu den Kodewörtern mit dem minimalen Gewicht am wahrscheinlichsten. Analog ist bei der Übertragung eines beliebigen Kodewortes A die Wahrscheinlichkeit einer Verfälschung hin zu einem Kodewort B am größten, welches eine minimale Distanz von $d_{min}$ zu Kodewort A besitzt.

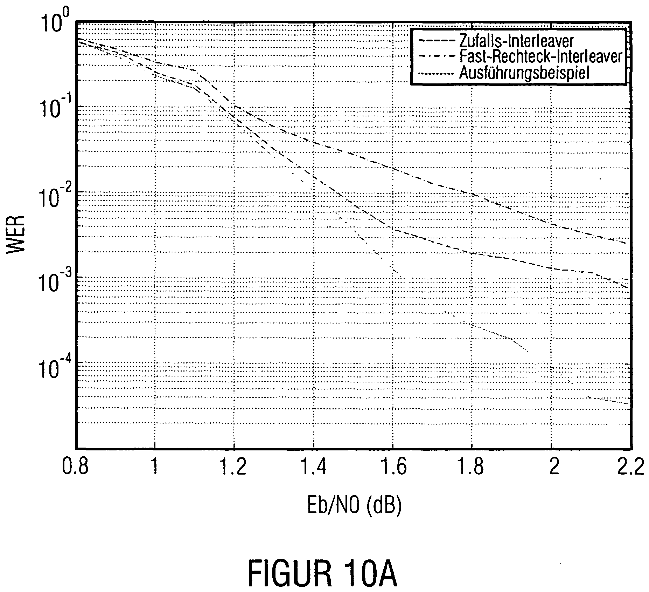

Es ist die Minimaldistanz $d_{min}$, die auch die Form der Wortfehlerraten-Kurve maßgeblich bestimmt. In solchen Wortfehlerraten-Kurven werden die Wortfehlerraten WER (WER = Word Error Rate, d.h. das Verhältnis der falsch dekodierten Kodewörter zur Gesamtzahl von übertragenen Kodewörtern) über einem wachsenden Signal-Rausch-Verhältnis (SNR = Signal-To-Noise-Ratio) für einen statischen nichtfrequenz-selektiven Kanal mit Additivem Weissen Gauss'schen Rauschen (AWGN = Additive White Gaussian Noise) dargestellt. In der Fig. 10a ist eine solche Kurve durch eine gestrichelte Linie dargestellt. Wird beispielsweise diese Linie betrachtet, so lässt sich erkennen, dass dieser einen Teil zwischen 1,2 und 1,6dB aufweist, in dem die WER-Kurve steiler abfällt, gefolgt von einem flacheren Kurventeil, der als sog. Error Floor oder Fehlerteppich bezeichnet wird. Die Lage des Error Floors wird hauptsächlich durch die Kodewörter mit Minimaldistanz $d_{min}$ vom übertragenen Kodewort verursacht.

Für kommerzielle Systeme ist es daher wünschenswert, dass ein solcher Error Floor naturgemäß begrenzt ist, weil eine zu hohe WER die Datenübertragung unzuverlässig macht, d.h. z. B. Signalaussetzer verursacht und auch innerhalb des Error Floors sogar durch Erhöhung des SNR die WER nicht wesentlich gesenkt werden kann.

Deshalb ist seit dem Aufkommen der Turbo Kodes beträchtliche Forschungsarbeit in die Reduzierung des Error Floors investiert worden, vgl. z.B. Marco Breiling, "Analysis and Design of Turbo Kode Interleavers", Shaker Verlag, Aachen, 2002 ISBN 3-8322-0302-8 und S. Crozier and P. Guinand: "High-performance low memory interleaver banks for turbo-codes", in Proc. of the 54th IEEE Veh. Tech. Conf (VTC'01), Atlantic City, pp. 2394-2398, Oct. 2001.

Für dieses Ziel wurden vielfältige Ansätze auch zur Optimierung von Turbo Kode Interleavern durchgeführt, beispielsweise gab es bei der UMTS-Standardisierung mehrere Vorschläge (UMTS = Universal Mobile Telecommunication System), vgl. Johan Hokfelt, Ove Edfors, and Torleiv Maseng: "Interleaver design for turbo codes based on the performance of iterative decoding", Intern. Conf. on Communications, Communications Theory Mini Conference, pages 93-97, 1999.

An den vorangegangenen Überlegungen lässt sich bereits erkennen, dass die Erzeugung von Gewicht im Turbo Kodierer berücksichtigt werden sollte, um die Methodik hinter dem Design von Turbo Kode Interleavern verständlich zu machen. Ein Kodewort mit dem Gewicht $d_{min}$ entsteht überhaupt nur dann, wenn das Informationswort ein niedriges Gewicht hat, da ja dieses selbst als systematischer Teil in das Kodewort mit eingeht. Wenn das Informationswort durch einen Vektor mit einer einzigen Eins dargestellt wird: 00...010...0, dann geschieht im 1. Komponentenkodierer 1105 folgendes: Bevor diese Eins in den Komponentenkodierer 1105 eingeht, gibt dieser an seinen Ausgängen nur Nullen aus, weil das interne Schieberegister des Komponentenkodierers 1105 nur Nullen enthält, vgl. Fig. 12.

Nachdem die Eins den Komponentenkodierer erreicht hat, enthält das Schieberegister nicht mehr nur Nullen, und durch den Rückkopplungszweig 1230 werden für den Rest dieses Informationswortes nicht mehr alle Flip-Flops 1200, 1205 und 1210 gleichzeitig Null sein. Das bedeutet, dass der Komponentenkodierer ab dem Zeitpunkt, zu dem eine einzelne Eins eingegeben wird, an seinen Ausgängen 1220; 1225 viele Einsen liefert. Die beiden Ströme von Paritätsbits haben also im Regelfall ein großes Gewicht, und Kodewörter, die von einer einzelnen Eins erzeugt werden, haben dementsprechend auch ein großes Gewicht.

Anders kann es aussehen, wenn am Eingang eines Komponentenkodierers ein Vektor anliegt, in dem zwei Einsen stehen, die eine bestimmte Entfernung zueinander haben, Entfernung ist hier im Sinne von Abstand der beiden Positionen innerhalb des Vektors zu verstehen. Der in der Fig. 12 gezeigte Komponentenkodierer liefert ein geringes Ausgangsgewicht u.a. für folgende Eingangsvektoren:

00..0100000010..0,
00..01000000000000010..0,
00..010000000000000000000010..0,

d.h. immer dann, wenn die Entfernung der Einsen ein Vielfaches von 7 Positionen ist. Der Teil des Vektors zwischen der einführenden und der abschließenden Eins einschließlich dieser Einsen, soll im Folgenden als Fehlermuster bezeichnet werden. Dieser Begriff rührt daher, dass diese Muster für Kodewörter verantwortlich sind, die bei einer fehlerhaften Übertragung des Null-Kodewortes vom Dekodierer fälschlicherweise ausgegeben werden. Die erste Eins führt jeweils dazu, dass das Schieberegister nicht mehr nur Nullen enthält und deshalb anfängt, Bits ungleich Null auszugeben, während die abschließende Eins dafür sorgt, dass das Schieberegister erneut nur Nullen enthält, es geht in den sog. Nullzustand zurück, und dass deshalb hernach nur noch Nullen ausgegeben werden.

Während 10000001 ein Fehlermuster ist, ist 1000001, d.h. die Entfernung zwischen den Einsen ist nur 6 Positionen, bzw. 100000001, d.h. die Entfernung ist 8 Positionen usw. kein Fehlermuster, d.h. hier geht das Schieberegister mit der 2. Eins nicht in den Nullzustand zurück und gibt deshalb auch anschließend weitere Einsen aus.

Zur Erhöhung von $d_{min}$ sollte demnach ein Turbo Kode Interleaver möglichst viele Fehlermuster am Eingang des 1. Komponentendekodierers 1305, die Paritätsbits eines ggf. nur niedrigen Gewichts erzeugen, derart permutieren, dass diese auf Folgen am Eingang des 2. Komponentendekodierer 1310 abgebildet werden, die keine Fehlermuster sind und deshalb ein hohes Paritätsgewicht erzeugen müssen.

Wie oben bereits erläutert, wirkt sich die Qualität des Turbo Kode Interleavers direkt auf den Error Floor der Wortfehlerraten-Kurve aus. Ein weiterer wichtiger Punkt ist die Implementierbarkeit des Turbo Kode Interleavers. Prinzipiell ist jeder Turbo Kode Interleaver als Adress-Tabelle implementierbar, d.h. für jedes Eingangsbit der 1. bzw. 2. Komponente steht in einer Tabelle sequentiell die Adresse, woher dieses Bit gelesen bzw. wohin es geschrieben werden soll, damit der entsprechend andere Komponentenkodierer es verarbeiten kann. Der Vorgang des Interleavens lässt sich dabei als Umordnung von Informationsbits in Speichern ausdrücken: wenn ein Informationsbit vor dem Interleaven in Adresse i eines ersten Speichers steht, so steht es nach dem Interleaven in Adresse Addr[i] entweder ebenfalls des ersten oder eines zweiten Speichers. Beispielsweise für 10.000 Informationsbits hätte diese Adress-Tabelle 10.000 Einträge mit jeweils 14 Bits, zur Darstellung von Adressen bis 10.000. Diese Adressen können in einem eigenen ROM (ROM = Read Only Memory) oder RAM (RAM = Random Access Memory) abgespeichert sein, was einen nicht unerheblichen Kostenaufwand bei der Implementierung nach sich zieht. Kritischer wird dieses Problem noch, wenn der Turbo Kode mehrere Wortgrößen unterstützen muss, wie es z.B. bei modernen Nachrichtensystemen sehr häufig der Fall ist. In diesem Fall wäre für jede Wortgröße eine eigene Tabelle notwendig, und der RAM- bzw. ROM-Bedarf summiert sich auf.

Aus diesem Grund gibt es auch im Bereich der konventionellen Technik bereits Bestrebungen, einen algorithmisch darstellbaren Turbo Kode Interleaver zu wählen. Hier wird die Permutationsadresse für jedes Informationsbit durch eine Vorschrift berechnet, welche sich durch wenige arithmetische Operationen sowie die Verwendung von wenigen Parametern darstellen lässt. Diese Parameter können für jede Wortgröße unterschiedliche Werten annehmen und in kleinen RAM- bzw. ROM-Tabellen abgespeichert werden.

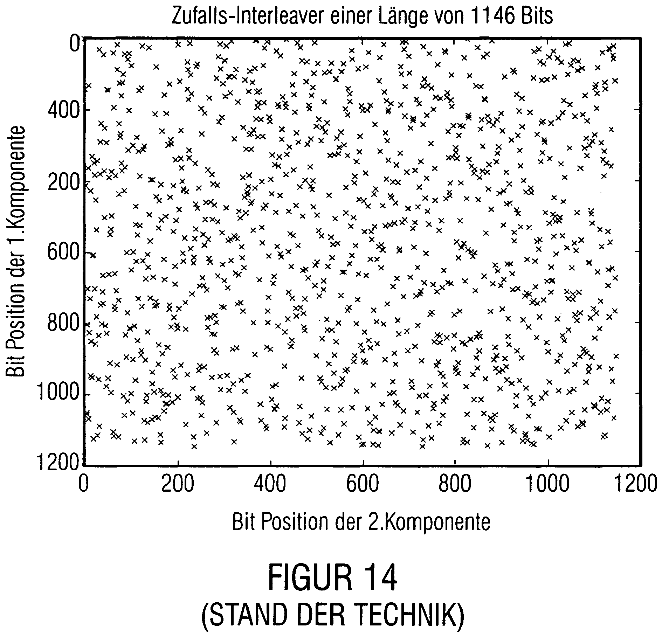

In der Anfangszeit von Turbo Kodes wurden als Turbo Kode Interleaver häufig zufällige Permutationen gewählt, wie es beispielsweise in der Fig. 14 dargestellt ist. Die Fig. 14 zeigt einen zufälligen Turbo Kode Interleaver, der auf einer Interleaver-Länge von 1146 Bits basiert. Die Darstellung in der Fig. 14 zeigt die Bitposition der 1. Komponente auf der Ordinate, und die Bitposition der 2. Komponente auf der Abszisse. Die jeweilige Zuordnung ist durch ein Kreuz dargestellt, wobei die Verteilung der Kreuze auf die zufällige Natur des Turbo Kode Interleavers hinweist. Bezüglich Zufallsinterleavern lässt sich zeigen, dass diese mit an Sicherheit grenzender Wahrscheinlichkeit Fehlermuster am Eingang des 1. Komponentendekodierers in Fehlermuster am Eingang des 2. Komponentendekodierers permutieren, so dass ein Kodewort mit niedrigem Gewicht erzeugt wird, vgl. Sergio Benedetto and Guido Montorsi: "Unveiling Turbo Codes: Some Results on Parallel Concatenated Coding Schemes", IEEE Trans. on Inform. Theory, 42(2):409-428, 1996.

Die WER eines Zufallsinterleavers ist neben anderen in der Fig. 10a gezeigt und dort als gestrichelte Linie mit der Bezeichnung "Zufalls-Interleaver", bezeichnet. Hier ist der Error Floor deutlich erkennbar. Nachteilig an Zufallsinterleavern ist ferner, dass sie nicht algorithmisch darstellbar sind, so dass sie als Tabelle gespeichert werden müssen.

Im Rahmen der konventionellen Technik sind ferner Linear Congruente Interleaver bekannt. Im Gegensatz zu Zufallsinterleavern sind diese Interleaver mathematisch streng beschreibbar. Die Adresse Addr[i] eines Informationsbits i kann nach der Formel

$$\text{Addr[i]} = (C \times i) \bmod K$$

berechnet werden, wobei mod die modulo-Operation darstellt, K die Informationswortgröße ist und C eine Konstante ist, die relativ prim zu K sein muss und das Inkrement zwischen aufeinanderfolgenden Adressen darstellt. Diese Interleaver besitzen einen hohen Error Floor, so dass sie in der Praxis nur selten zum Einsatz kommen.

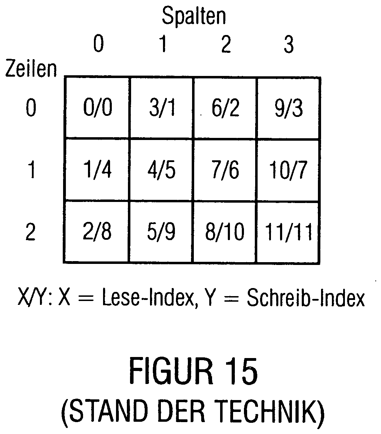

In der Anfangszeit der Turbo Kodes wurden in der Forschung statt der Zufallsinterleaver auch Rechteck-Interleaver verwendet. Ein Beispiel eines Rechteck-Interleavers ist in der Fig. 15 dargestellt. Die Fig. 15 zeigt eine Rechteckdarstellung mit 3 Zeilen und 4 Spalten, wobei in die jeweiligen Felder jeweils der Lese- bzw. Schreibindex eingetragen ist. Wie aus der Fig. 15 hervorgeht, muss die Informationswortgröße gleich dem Produkt aus Zeilen- und Spaltenanzahl sein. In diese werden die zu permutierenden Bits zeilenweise geschrieben und spaltenweise gelesen. Die Leistungsfähigkeit dieser Interleaver ist ebenfalls ungenügend.

An den Extrembeispielen Zufallsinterleaver auf der einen Seite und Rechteck-Interleaver bzw. linear kongruenter Interleaver auf der anderen Seite lässt sich erkennen, dass sowohl ein zu zufälliger als auch ein zu strukturierter Aufbau eines Turbo Kode Interleavers zu einer schlechten Leistungseffizienz des Kodes führt.

Aus der Literatur sind weiterhin s-Random-Interleaver bekannt, vgl. S. Dolinar and D. Divsalar: "Weight Distributions for Turbo Codes Using Random and Nonrandom Permutations", Jet Propulsion Lab, TDA Prog. Rep., 42-122: 56-65, 1995, bei denen die Permutation in gewissem Maß pseudozufällig ist, wobei aber dem Zufall hier ein paar Einschränkungen gesetzt werden bzgl. der Abstände, die die Positionen von 2 beliebigen Bits in der 1. und 2. Komponente haben dürfen. Mit diesen s-Random-Interleavern lässt sich eine recht gute Leistungsfähigkeit des Turbo Kodes erreichen. Der Nachteil ist hier, ähnlich zu den Zufallsinterleavern, dass keine algorithmische Berechnungsformel des Interleavers angegeben werden kann.

Ein Interleaver, der viele Eigenschaften des s-Random-Interleavers besitzt, der aber dennoch algorithmisch beschreibbar ist, ist der Dithered Relatively Prime-Interleaver, vgl. S. Crozier and P. Guinand: "High-performance low-memory interleaver banks for turbo-codes", in Proc. Of the 54th IEEE Veh. Tech. Conf (VTC'01), Atlantic City, pp. 2394-2398, Oct. 2001. Dieser Interleaver stellt eine Mischung aus Pseudo-Zufall und Struktur, sowie mit vorgeschriebenen Abständen der Bitpositionen dar. Er basiert auf dem Linear Congruenten Interleaver mit einer zusätzlich überlagerten lokalen Permutation, um die starre Struktur des Linear Congruenten Interleavers aufzubrechen.

Ein weiterer bekannter Interleaver ist der UMTS- bzw. 3GPP-Interleaver (3GPP = Third Generation Partnership Project), siehe W-CDMA 3GPP TS 3rd Generation Partnership Project; Technical Specification Group Radio Access Network; Multiplexing and channel coding (FDD), sowie Hirohito Suda and Akira Shibutani: "Interleaving method, interleaving apparatus, turbo encoding method, and turbo encoder", European Patent 1 030 455 B1, 1999. Das Grundprinzip hinter dem Turbo Kode Interleaver, der beim 3GPP-Standard verwendet wird, ist ein Rechteck-Interleaver, der in der Folge als Rahmeninterleaver bezeichnet wird, bei dem zusätzlich Intra- und Inter-Zeilen-Interleaving durchgeführt wird. Das bedeutet, dass zunächst in einem 1. Schritt die Informationsbits zeilenweise in einen Rechteck-Interleaver geschrieben werden. Anschließend wird innerhalb jeder Zeile nochmals permutiert, sogen. Intra-Zeilen-Interleaving, wobei die Permutation in jeder Zeile unterschiedlich ist. Beim 3GPP-Interleaver wird diese Permutation auf der Basis von Zyklen durchgeführt, die in einem Galois-Feld durch Potenzierung eines primitiven Elements erzeugt werden. Das so entstehende Intra-Zeilen-Interleaving kann in etwa mit einer pseudozufälligen Permutation verglichen werden.

Anschließend werden in einem 3GPP-Interleaver noch ganze Zeilen miteinander vertauscht, sog. Inter-Zeilen-Interleaving. Nachdem Intra- und Inter-Zeilen-Interleaving durchgeführt worden sind, wird der derart permutierte Rechteck-Rahmen-Interleaver spaltenweise ausgelesen.

Beim 3GPP-Interleaver ist zusätzlicher Aufwand erforderlich, um den Interleaver an die Wortgröße anzupassen. Dafür werden vor der Permutation Dummy-Bits an das Informationswort angehängt, so dass das derart ergänzte Wort vollständig einen Rechteck-Interleaver ausfüllt, die Länge des aufgefüllten Eingangswortes ergibt sich dann aus dem Produkt aus Zeilen- und Spaltenzahl. Nach der Permutation müssen diese Dummy-Bits wieder entfernt werden, d. h. es wird ein sog. Pruning durchgeführt. Die Permutation beim 3GPP-Interleaver setzt sich somit aus einer Reihe von Einzeloperationen zusammen.

Der Nachteil durch die Behandlung von Dummy-Bits, d.h. deren Einfügen, ihr Anteil an den durchgeführten Permutationen und das Entfernen, ist, dass zusätzliche Prozessierungszeit, Ressourcenverbrauch, beispielsweise zusätzlicher Speicherbedarf, und zusätzlicher Implementierungsaufwand, d.h. Komplexität, benötigt wird.

Um sich das tatsächliche Hinzufügen und spätere Entfernen der Dummy-Bits zu den "echten" Informationsbits zu sparen, wäre es nützlich, den Index eines interleaveten Informationsbits, d.h. nach dem vollständigen Interleave-Vorgang und dem Lesen aus dem Interleaverspeicher, unmittelbar berechnen zu können. Es wäre also eine Berechnungsvorschrift wünschenswert, die den Index eines Informationsbits im interleaveten Informationswort direkt angeben kann, wie sie durch den o.a. Vorgang von Dummy-Bit-Hinzufügen, Interleaven und Dummy-Bit-Entfernen resultieren würde, jedoch ohne dass dieses Hinzufügen und Entfernen von Dummy-Bits wirklich durchgeführt werden muss.

Eine einfache Berechnungsvorschrift kann aber nicht angegeben werden, weil der 3GPP-Interleaver folgenden Nachteil hat: Der Rahmeninterleaver dieses Standards ist immer ein Rechteck-Interleaver, dessen Elementezahl das Produkt aus Zeilen- und Spaltenzahl ist. Da die Blockgröße beliebig wählbar ist, müssen zwangsläufig - wie oben beschrieben - zusätzliche Dummy-Bits eingefügt werden, und nach dem Interleaving wieder entfernt werden. Alle Zeilen des Rahmeninterleavers sind nach dem Einfügen der Dummy-Bits gleich lang, und alle Intra-Zeilen-Interleaver arbeiten deshalb mit der gleichen Zeilenlänge. Die Dummy-Bits werden deshalb durch die Intra- und Inter-Zeilen-Permutationen in der Regel über den ganzen Rahmen-Interleaver verstreut. Außerdem kann die Anzahl von Dummy-Bits in verschiedenen Zeilen unterschiedlich sein. Die unregelmäßige Verteilung der Dummy-Bits über den gesamten Rahmen-Interleaver erlaubt keine einfache direkte Berechnung für den Index des interleaveten Informationsbits (nach Intra- und Inter-Zeilen-Permutation und Auslesen), da diese Unregelmäßigkeiten in der Formel Berücksichtigung finden müssten.

Auch beim cdma2000- bzw. 3GPP2-Interleaver (siehe CDMA-2000 3GPP2 C.S0002-C Version 2.0 Physical Layer Standard for cdma2000 Spread Spectrum Systems Revision C, sowie Douglas N. Rowitch and Fuyun Ling: "Turbo Code Interleaver using Linear Congruential Sequence", US Patent 6 304 991 B1, 1998, und Steven J. Halter: "Random-Access Multi-Directional CDMA2000 Turbo Code Interleaver", US Patent 6 871 303 B2, 2001) wird grundsätzlich ein Rahmeninterleaver in Form eines Rechteck-Interleavers verwendet, bei dem ein Intra- und ein Inter-Zeilen-Interleaving durchgeführt wird. Hier basiert das Intra-Zeilen-Interleaving auf einem Linear Congruenten Interleaving, das ebenfalls eine quasizufällige Permutation bewirken soll, während das Inter-Zeilen-Interleaving durch eine stellenmäßige Umkehrung der Bitdarstellung des jeweiligen Zeilenindexes (bit reversal) erreicht wird.

Beim 3GPP2-Interleaver ist ebenfalls zusätzlicher Aufwand erforderlich, um den Interleaver an die gewählte Wortgröße anzupassen, da das Produkt aus Zeilen- und Spaltenanzahl in der Regel ungleich der Informationswortgröße ist. Es müssen daher stets 2 Kandidaten-Adressen für ein Informationsbit erzeugt werden, die zwischen Null und dem Produkt aus Zeilen- und Spaltenanzahl liegen. Falls die erste Kandidaten-Adresse gültig ist, d.h. zwischen Null und der Informationswortgröße liegt, wird sie verwendet, ansonsten wird sie verworfen und die zweite Kandidaten-Adresse verwendet, die in diesem Fall immer gültig ist (das lässt sich für den verwendeten Algorithmus zeigen).

Während der Rahmen-Interleaver des 3GPP2-Standards immer ein Rechteck-Interleaver ist, kann die Informationswortgröße hier in gewissen Stufen gewählt werden, und für jede Informationswortgröße gibt es eigene Parametersätze für den Interleaver. Die Informationswortgrößen sind in der Regel ungleich der Anzahl von Elementen des Rechteck-Rahmen-Interleavers (Produkt aus Zeilen- und Spaltenanzahl). Obwohl bei dieser Interleaver-Konstruktion kein Auffüllen des Rahmen-Interleavers mit Dummy-Bits nötig ist, ist auch hier eine einfache unmittelbare Berechnung der Adresse eines Informationsbits nicht möglich.

Eine Eigenheit des 3GPP2-Interleavers ist nämlich, dass in der Adress-Berechnungsvorschrift ein Counter-Wert vorkommt, der ungleich dem Index des Bits ist, das permutiert werden soll. Ist beispielsweise eine Blockgröße von 378 Bits gewählt, dann geht der Bit-Index von 0 - 377, während der Counter-Wert alle Werte von 0 bis 511 durchschreitet. Für die Berechnung der Adresse von Bit mit Index Null wird auch der Counter-Wert Null verwendet, aber bereits für das Bit mit Index 3 wird nicht mehr der Counter-Wert 3, sondern 4 verwendet, hingegen wird der Counter-Wert 3 verworfen. Dies liegt am Algorithmus aus dem 3GPP2-Standard, der Kandidaten-Adressen erzeugt, die für manche Indizes ungültig sind. Die Ursache hierfür liegt darin, dass das Inter- und Intra-Zeilen-Interleaving immer davon ausgeht, dass jede Zeile bzw. Spalte vollständig und gleich lang ist.

Ohne den oben genannten Counter und die Erzeugung von möglicherweise ungültigen Kandidaten-Adressen ist deren Berechnung nicht durchführbar. Nachteilig an diesem Verfahren ist eben gerade das Erzeugen ungültiger Adressen, die verworfen werden müssen, wodurch wiederum mehr Prozessierungszeit bzw. ein höherer Implementierungsaufwand zur parallelen Erzeugung zweier Adressen notwendig ist.

Es ist die Aufgabe der vorliegenden Erfindung, ein verbessertes Konzept zum Verwürfeln von Informationsworten zu schaffen.

Diese Aufgabe wird gelöst durch einen Interleaver gemäß Anspruch 1 und ein Verfahren gemäß Anspruch 8.

Die vorliegende Erfindung basiert auf dem Kerngedanken, dass Rechteck-Interleaver, für Informationsworte verwendet werden können, deren Länge nicht dem Produkt aus Zeilen- und Spaltenanzahl des Rechteck-Interleavers entspricht. Ausführungsbeispiele der vorliegenden Erfindung werden im Folgenden auch Fast-Rechteck-Interleaver genannt ("fast" im Sinne von "nahezu"). Insbesondere können diese Fast-Rechteck-Interleaver miteinander in einer Art und Weise verschachtelt werden, dass sich eine gute Interleaver-Qualität ergibt, d.h. dass ein Error Floor einer WER einer Turbokodierung entsprechend niedrig ausgestaltet ist. Gleichzeitig lassen sich diese Interleaver auf unterschiedliche Blockgrößen, d.h. Informationswortlängen anwenden, ohne dass sog. Dummy-Bits eingefügt werden, bzw. ohne dass Dummy-Adressen, d.h. ungültige Kandidaten-Adressen erzeugt werden. Ferner bieten die Fast-Rechteck-Interleaver die Möglichkeit, einfache Berechnungsvorschriften zwischen ursprünglichem Index eines Informationsbits (vor dem Interleaven) und der Adresse nach dem Interleaven zu implementieren, so dass vergleichsweise niedrige Anforderungen an Speicher und Prozessierungszeit gestellt werden müssen.

Ein weiterer Kerngedanke der vorliegenden Erfindung ist, dass innerhalb eines Fast-Rechteck-Interleavers, dessen Zeilen z.B. über weitere Fast-Rechteck-Interleaver in sich verwürfelt werden können. In anderen Worten, ist es ein Kerngedanke der vorliegenden Erfindung, dass verbesserte Interleaving-Ergebnisse durch Verschachteln von Fast-Rechteck-Interleaver erzeugt werden können, wobei die weiteren Fast-Rechteck-Interleaver ein Intra-Zeilen-Interleaving des 1. Fast-Rechteck-Interleavers vornehmen können. In Ausführungsbeispielen kann ein zusätzlicher Fast-Rechteck-Interleaver zum Einsatz kommen, z.B. um ein Inter-Zeilen-Interleaving durchzuführen. Ausführungsbeispiele der vorliegenden Erfindung bilden somit den Vorteil, dass gute Interleaving-Ergebnisse mit geringem Aufwand und geringen Hardware-Anforderungen erzeugt werden können.

Im Folgenden werden Ausführungsbeispiele der vorliegenden Erfindung anhand der beiliegenden Figuren näher erläutert. Es zeigen

Fig. 1a     ein Ausführungsbeispiel eines Fast-Rechteck-Interleavers;

Fig. 1b     ein Flussdiagramm eines Ausführungsbeispiels eines Verfahrens zum Generieren eines Ausgangsindex;

Fig. 2      eine Darstellung einer Index-Permutation eines Ausführungsbeispiels eines Fast-Rechteck-Interleavers;

Fig. 3      ein Fehlermuster eines Ausführungsbeispiels eines Fast-Rechteck-Interleavers;

Fig. 4      ein weiteres Ausführungsbeispiel eines Fast-Rechteck-Interleavers;

Fig. 5        ein Ausführungsbeispiel eines Intra-Zeilen-Fast-Rechteck-Interleavers;

Fig. 6        eine Illustration einer Index-Permutation mit einem Ausführungsbeispiel eines Fast-Rechteck-Interleavers;

Fig. 7        eine Illustration eines Ausführungsbeispiels eines Inter-Zeilen-Fast-Rechteck-Interleavers;

Fig. 8        eine weitere Illustration eines Inter-Zeilen-Fast-Rechteck-Interleavers;

Fig. 9        eine Illustration einer Index-Permutation eines Ausführungsbeispiels mit verschachtelten Fast-Rechteck-Interleavern;

Fig. 10a      Simulationsergebnisse unter Verwendung eines Ausführungsbeispiels mit Hilfe von Wortfehlerraten;

Fig. 10b      Simulationsergebnisse zum Vergleich eines Ausführungsbeispiels mit einem 3GPP2 Interleaver;

Fig. 10c      weitere Simulationsergebnisse zum Vergleich eines Ausführungsbeispiels mit einem 3GPP2 Interleaver;

Fig. 11       ein Blockschaltbild eines Turbo Kodierers;

Fig. 12       ein Blockschaltbild eines Faltungskodierers;

Fig. 13       ein Blockschaltbild eines Turbo Dekodierers;

Fig. 14       eine Indexpermutation eines Zufallsinterleavers;

Fig. 15       eine Illustration eines Rechteck-Interleavers.

Im Folgenden werden Ausführungsbeispiele der vorliegenden Erfindung im Detail erläutert.

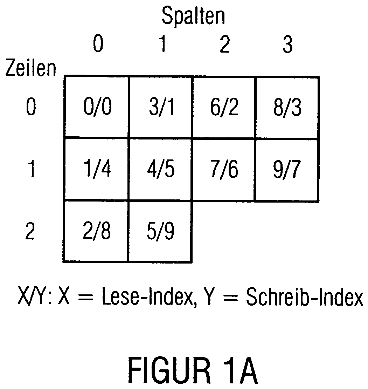

Im Folgenden wird zunächst die Funktion eines Ausführungsbeispiels eines Fast-Rechteck-Interleavers erläutert. Der Fast-Rechteck-Interleaver unterscheidet sich dadurch von einem Rechteck-Interleaver, dass beim Fast-Rechteck-Interleaver die Anzahl von Bits oder Stellen ungleich des Produkts aus Zeilen- und Spaltenanzahl sein kann, wie dies beispielhaft in der Fig. 1a dargestellt ist. Die Fig. 1a zeigt eine Anordnung aus 3 Zeilen mit den Indizes 0, 1, 2 sowie 4 Spalten 0, 1, 2, 3, in die lediglich 10 Indizes von 0 bis 9 eingetragen sind. Es ist zu erkennen, dass in der Fig. 1a die Spalten 2 und 3 nur 2 Stellen enthalten, wohingegen die Spalten 0 und 1 je 3 Stellen aufweisen. In anderen Worten ausgedrückt, weisen die Zeilen 0 und 1 jeweils 4 Elemente auf, wohingegen die Zeile 2 lediglich 2 Elemente aufweist. In die einzelnen Zellen oder Elemente, sind jeweils zunächst ein Leseindex X und ein Schreibindex Y eingetragen, wobei X und Y durch einen Schrägstrich getrennt sind. Es ist zu erkennen, dass der Fast-Rechteck-Interleaver zunächst zeilenweise beschrieben wird und dann spaltenweise ausgelesen wird.

Im Folgenden werden Ausführungsbeispiele solcher Interleaver als Fast-Rechteck-Interleaver bezeichnet. Diese Interleaver werden - wie "normale" Rechteck-Interleaver - zeilenweise geschrieben und spaltenweise gelesen, wobei jedoch die letzte Zeile bzw. die letzten Spalten kürzer als die vorangehenden sein können. Allgemein kann in Ausführungsbeispielen auch spaltenweise geschrieben und zeilenweise gelesen werden. Generell werden die betrachteten Vektoren, d.h. z.B. Komponenten, Elemente oder Stellen eines Informationswortes in eine Matrix-artige Form gebracht, d.h. in Zeilen und Spalten gitterförmig angeordnet, wobei nicht alle Zeilen und Spalten voll besetzt sein müssen. Durch Transponieren können zeilen- und spaltenweise Operationen ineinander überführt werden. Ferner werden im Folgenden die Begriffe Komponenten, Elemente, Stellen äquivalent dazu verwendet, eine Position in einem Vektor bzw. in einer Matrix zu bezeichnen. Komponenten, Elemente und Stellen können eine oder mehrere Binärstellen umfassen, sind jedoch nicht darauf beschränkt.

Im Folgenden sei davon ausgegangen, dass Num_Bits die Anzahl von Informationsbits sei, d.h. die Anzahl der Elemente des Interleavers, und Num_Cols die Spaltenanzahl ist. Es ergibt sich folglich, dass die Anzahl Num_Full_Rows vollständige Zeilen und die Anzahl Num_Rem_Bits von Bits in der unvollständigen, d.h. letzten Zeile, falls eine solche vorhanden ist, wie folgt berechnet werden kann:

$$\text{Num\_Full\_Rows} = \text{Floor}\left(\text{Num\_Bits/Num\_Cols}\right),$$

$$\text{Num\_Rem\_Bits = Num\_Bits mod Num\_Cols,}$$

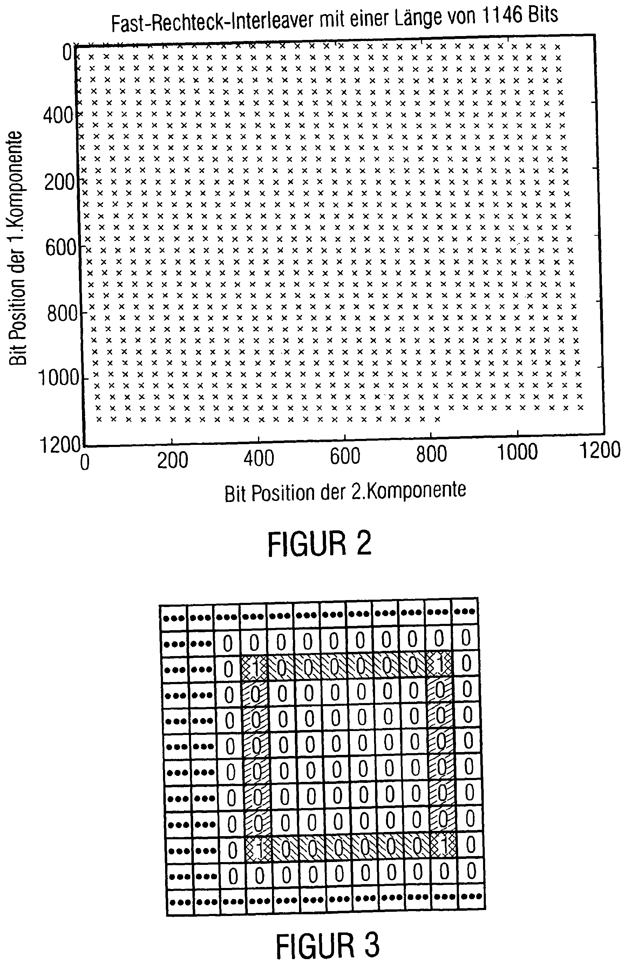

wobei die Floor-Funktion das Runden zur nächsten ganzen Zahl kleiner oder gleich des Arguments bewirkt. Eine solche Permutationsvorschrift ist ferner in Form eines Index-Diagramms in der Fig. 2 gezeigt. Die Fig. 2 zeigt eine Zuordnung zwischen den Bitpositionen der 2. Komponente auf der Abszisse und der Bitposition der 1. Komponente auf der Ordinate, wie sie in einem Ausführungsbeispiel erzeugt werden kann. Gemäß dem oben stehenden Beispiel wird von einem Fast-Rechteck-Interleaver mit einer Länge von Num_Bits = 1146 Bits mit Num_Cols = 34 Spalten ausgegangen. Die Fig. 2 zeigt, dass die letzte Zeile unvollständig ist, wie im unteren rechten Bereich zu erkennen ist.

Ein Fast-Rechteck-Interleaver geht in einen Rechteck-Interleaver über, wenn die letzte Zahl bzw. die letzten Spalten vollständig sind und somit die Anzahl von Bits gleich dem Produkt aus Zeilen- und Spaltenanzahl ist.

Ausführungsbeispiele von Fast-Rechteck-Interleavern haben den großen Vorteil, dass die oben geschriebenen Fehlermuster gut auseinandergerissen werden können, d.h. wenn die Entfernung der Einsen in der 1. Komponente gering ist, so dass der 1. Komponentenkodierer nur wenige Einsen an seinem Ausgang erzeugt, dann ist die Entfernung dieser Einsen nach der Permutation, also am Eingang des 2. Komponentenkodierers groß, und in der 2. Komponente werden viele Einsen, d.h. ein hohes Gewicht, erzeugt.

In der Simulation erweist sich jedoch ein einzelner Fast-Rechteck-Interleaver in einem Turbo Kode als wenig nützlich. Auch hier tritt ein Error Floor auf, weil die Minimaldistanz $d_{min}$ zu niedrig ist, wie die strich-punktierte Kurve mit der Bezeichnung "Fast-Rechteck-Interleaver" in der Fig. 10a zeigt.

Die Fig. 3 zeigt eine weitere schematische Darstellung eines Ausführungsbeispiels eines Fast-Rechteck-Interleavers, die die Erhöhung des Error Floors anhand eines Fehlermusters näher erläutern soll. In der Fig. 3 lässt sich der Grund für den erhöhten Error Floor erkennen. Im Informationswort befinden sich 4 Einsen, die im Fast-Rechteck-Interleaver an den Ecken eines Rechteckes bzw. eines Quadrates stehen. Wenn das Informationswort nun zeilenweise in die Interleaver-Matrix geschrieben wird, steht in 2 Zeilen das Fehlermuster 10000001. Dieses Fehlermuster wird also auch 2 mal am Eingang des 1. Komponentenkodierers auftreten, so dass dieser eine Folge von Paritätsbits niedrigen Gewichts ausgibt. Aber auch an 2 Spalten erscheint auf diese Art und Weise dieses Fehlermuster, was bedeutet, dass es auch 2 mal am Eingang des 2. Komponentenkodierers auftritt und hier ebenfalls ein niedriges Paritätsgewicht erzeugt. Die 4 Einsen sind demnach also derart im Fast-Rechteck-Interleaver angeordnet, dass ein Kodewort niedrigen Gewichts erzeugt wird.

Diese negative Eigenschaft wirkt sich sogar noch stärker aus, wenn dieses Rechteck, dessen Ecken durch die 4 Einsen gebildet werden, beliebig innerhalb des Fast-Rechteck-Interleavers verschoben wird, da bei jeder Verschiebung eine ungünstige Anordnung mit resultierendem niedrigen Kodewort-Gewicht entsteht. Diese Kombinationen sind für den erhöhten Error Floor verantwortlich. Ein einzelner Fast-Rechteck-Interleaver liefert demnach noch nicht die gewünschte Leistungsfähigkeit für Turbo Kodes und erscheint daher wenig praxistauglich.

Die Ausführungsbeispiele der vorliegenden Erfindung umfassen einen Interleaver zum Verwürfeln eines Informationswortes, wobei das Informationswort eine Vielzahl von Stellen aufweist, um ein permutiertes Informationswort zu erhalten. Der Interleaver kann dabei eine erste Interleaverstufe (Rahmen-Interleaver) zum zeilenweisen Anordnen der Stellen des Informationswortes in einer Mehrzahl von ersten Zeilen und ersten Spalten aufweisen, wobei die ersten Zeilen mindestens eine erste Zeile mit einer Lücke aufweisen und die ersten Spalten wenigstens eine erste Spalte mit einer Lücke aufweisen. Ferner kann der Interleaver eine zweite Interleaverstufe zum Verwürfeln der Stellen der einen ersten Zeile mit der Lücke durch Vertauschen wenigstens zweier Stellen der einen ersten Zeile umfassen, so dass eine Position der Lücke unverändert bleibt, um eine erste verwürfelte Zeile zu erhalten, und zum Ersetzen der einen der ersten Zeilen mit der ersten verwürfelten Zeile. Die erste Interleaverstufe kann ausgebildet sein, um die ersten Spalten spaltenweise auszulesen und die Stellen der ersten Spalten lückenlos aneinander zu reihen, um das permutierte Informationswort zu erhalten.

In Ausführungsbeispielen kann die zweite Interleaverstufe ausgebildet sein, um die Stellen der einen ersten Zeile durch eine linear congruente Interleaver-Regel zu Verwürfeln, so dass eine Position der Lücke unverändert bleibt, um die erste verwürfelte Zeile zu erhalten, und zum Ersetzen der einen der ersten Zeilen mit der ersten verwürfelten Zeile.

Die zweite Interleaverstufe kann ferner ausgebildet sein, um die Stellen der einen ersten Zeile zeilenweise in einer Mehrzahl von zweiten Zeilen und zweiten Spalten anzuordnen, und zum spaltenweisen Auslesen der Stellen, um eine erste verwürfelte Zeile zu erhalten und zum Ersetzen der einen der ersten Zeilen mit der ersten verwürfelten Zeile. Die erste Interleaverstufe kann ferner ausgebildet sein, um die ersten Zeilen spaltenweise und lückenlos auszulesen, um das permutierte Informationswort zu erhalten.

In Ausführungsbeispielen kann der Interleaver ferner eine dritte Interleaverstufe aufweisen, zum zeilenweisen Anordnen von Zeilenindizes der ersten Zeilen in dritten Zeilen und dritten Spalten, und zum spaltenweisen Auslesen der Zeilenindizes, um verwürfelte Zeilenindizes zu erhalten, und zum Vertauschen der ersten Zeilen bzw. ersten verwürfelten Zeilen basierend auf den verwürfelten Zeilenindizes. Die erste Interleaverstufe kann dann ausgebildet sein, um die basierend auf den verwürfelten Zeilenindizes vertauschten ersten Zeilen spaltenweise und lückenlos auszulesen, um das permutierte Informationswort zu erhalten.

In Ausführungsbeispielen können die Stellen des Informationswortes Softbits oder Symbole mit mehr als 2 Werten, d.h. eine Mehrzahl von Binärstellen pro Stelle oder Element des Informationswortes umfassen. In anderen Ausführungsbeispielen kann jede Stelle des Informationswortes genau eine Binärstelle umfassen.

In weiteren Ausführungsbeispielen kann die erste Interleaverstufe ausgebildet sein, um die Stellen des Informationswortes in einer Anzahl von ersten Zeilen und einer Anzahl von ersten Spalten anzuordnen, wobei das Informationswort eine Anzahl von Stellen aufweist, die kleiner als das Produkt aus der Anzahl von ersten Zeilen und der Anzahl von ersten Spalten ist und die erste Interleaverstufe ferner ausgebildet ist, um beim spaltenweisen Auslesen auftretende Lücken zu überspringen, d.h. lückenlos auszulesen.

In Ausführungsbeispielen kann auch die zweite Interleaverstufe ausgebildet sein, um die Stellen der einen der ersten Zeilen in einer Anzahl von zweiten Zeilen und einer Anzahl von zweiten Spalten einzuordnen, wobei die eine der ersten Zeilen eine Anzahl von Stellen aufweist, die kleiner als das Produkt der Anzahl von zweiten Zeilen und der Anzahl von zweiten Spalten ist und die zweite Interleaverstufe ferner ausgebildet ist, um beim spaltenweisen Auslesen auftretende Lücken zu überspringen bzw. lückenlos auszulesen.

In Ausführungsbeispielen kann ferner die dritte Interleaverstufe ausgebildet sein, um die Zeilenindizes in einer Anzahl von dritten Zeilen und einer Anzahl von dritten Spalten anzuordnen, wobei die Anzahl von Zeilenindizes kleiner als das Produkt aus der Anzahl von dritten Zeilen und dritten Spalten ist, und die dritte Interleaverstufe ferner ausgebildet ist, um beim spaltenweisen Auslesen auftretende Lücken zu überspringen bzw. lückenlos auszulesen.

In Ausführungsbeispielen können die erste, die zweite, oder die dritte Interleaverstufe ausgebildet sein, um als Informationswort einen Vektor von Lese- oder Schreibadressen zu verwürfeln. In anderen Worten können Ausführungsbeispiele auch dazu verwendet werden, entsprechende Lese- und Schreibadressen zu verwürfeln und somit auch Interleaver- bzw. De-Interleaver-Vorschriften zu realisieren. In anderen Worten können anstatt einem Informationswort selbst Leseadressen verwürfelt werden und eine Interleaver-Vorschrift durch verwürfeltes Auslesen realisiert werden. Ein verwürfeltes Informationswort kann rückverwürfelt werden, d.h. in den Ursprungszustand zurückversetzt werden, in dem Schreibadressen gemäß den Indizes des Informationswortes verwürfelt werden, und die Stellen des verwürfelten Informationswortes entsprechend an die verwürfelten Schreibadressen geschrieben werden.

Ausführungsbeispiele von Interleavern können auch eine erste Interleaverstufe (Rahmeninterleaver) zum zeilenweisen Anordnen der Stellen des Informationswortes in einer Mehrzahl von ersten Zeilen und ersten Spalten umfassen. Ferner können die Interleaver eine zweite Interleaverstufe zum Verwürfeln der Stellen einer der ersten Zeilen durch zeilenweises Anordnen der Stellen der einen ersten Zeile in einer Mehrzahl von zweiten Zeilen und zweiten Spalten aufweisen, wobei die zweiten Zeilen mindestens eine zweite Zeile mit einer Lücke aufweisen und die zweiten Spalten wenigstens eine zweite Spalte mit einer Lücke aufweisen, und wobei die zweite Interleaverstufe ausgebildet sein kann, um die Stellen der zweiten Spalten spaltenweise auszulesen und lückenlos aneinander zu reihen, um eine erste verwürfelte Zeile zu erhalten, und zum Ersetzen der einen der ersten Zeilen mit der ersten verwürfelten Zeile, wobei die erste Interleaverstufe ausgebildet sein kann, um die ersten Spalten spaltenweise auszulesen, um das permutierte Informationswort zu erhalten.

In Ausführungsbeispielen kann die erste Interleaverstufe ausgebildet sein, zum zeilenweisen Anordnen der Stellen des Informationswortes in einer Mehrzahl von ersten Zeilen und ersten Spalten, wobei die ersten Zeilen mindestens eine erste Zeile mit einer Lücke aufweisen und die ersten Spalten wenigstens eine erste Spalte mit einer Lücke aufweisen, wobei die erste Interleaverstufe ausgebildet sein kann, um die ersten Spalten spaltenweise auszulesen und die Stellen der ersten Spalten lückenlos aneinander zu reihen, um das permutierte Informationswort zu erhalten.

Ausführungsbeispiels können ferner eine dritte Interleaverstufe aufweisen, die ausgebildet ist, zum zeilenweisen Anordnen von Zeilenindizes der ersten Zeilen in dritten Zeilen und dritten Spalten, und zum spaltenweisen Auslesen der Zeilenindizes um verwürfelte Zeilenindizes zu erhalten und zum Vertauschen der ersten Zeilen basierend auf den verwürfelten Zeilenindizes, wobei die erste Interleaverstufe ausgebildet ist, um die basierend auf den verwürfelten Zeilenindizes vertauschten ersten Zeilen spaltenweise auszulesen, um das permutierte Informationswort zu erhalten.

Gemäß obiger Erläuterung können die erste, zweite und/oder dritte Interleaverstufe ausgebildet sein, um ein Informationswort zu verarbeiten, bei dem jede Stelle eine Binärstellen umfasst. Die dritte Interleaverstufe kann ausgebildet sein, um die Zeilenindizes in einer Anzahl von dritten Zeilen und einer Anzahl von dritten Spalten anzuordnen, wobei die Anzahl der Zeilenindizes kleiner ist als das Produkt aus der Anzahl von dritten Zeilen und der Anzahl von dritten Spalten und die dritte Interleaverstufe ferner ausgebildet ist, um beim spaltenweisen Auslesen auftretende Lücken zu überspringen. In anderen Worten können beliebige der ersten, zweiten und dritten Interleaverstufe als Fast-Rechteck-Interleaver ausgeführt sein. Die erste, zweite und/oder dritte Interleaverstufe können ausgebildet sein, um als Informationswort einen Vektor von Lese- oder Schreibadressen zu verwürfeln.

Ausführungsbeispiele können einen Indexgenerator zum Generieren eines Ausgangsindex basierend auf einem Eingangsindex, einer Spaltenzahl, einer Elementzahl und einer Information über eine un-vollständige Zeile aufweisen. Der Indexgenerator umfasst eine Einrichtung zum Generieren eines Zeilenindex basierend auf dem Eingangsindex und der Spaltenzahl und eine Einrichtung zum Generieren eines Spaltenindex basierend auf dem Eingangsindex und der Spaltenzahl. Ferner umfasst der Indexgenerator eine Einrichtung zum Generieren einer Vollzeilenzahl basierend auf der Elementzahl und der Spaltenzahl und eine Einrichtung zum Generieren einer Restelementzahl basierend auf der Elementzahl und der Spaltenzahl. Der Indexgenerator kann ferner eine Einrichtung zum Ausgeben des Ausgangsindex umfassen, die ausgebildet ist, um für den Fall, dass der Spaltenindex kleiner als die Restelementzahl ist, den Ausgangs-index als

$$\text{Ausgangsindex} = (\text{Vollzeilenzahl} + 1)\,\text{Spaltenindex} + \text{Zeilenindex}$$

auszugeben,
und sonst,
für den Fall, dass die Information über die unvollständige Zeile angibt, dass keine unvollständige Zeile vorhanden ist oder der Zeilenindex kleiner oder gleich einem Index einer unvollständigen Zeile ist,
den Ausgangsindex als

$$\text{Ausgangsindex} = (\text{Vollzeilenzahl}+1)\,\text{Restelementzahl} + \text{Vollzeilenzahl}\,(\text{Spaltenindex}-\text{Restelementzahl}) + \text{Zeilenindex}$$

auszugeben,
und sonst
den Ausgangsindex als

$$\text{Ausgangsindex} = (\text{Vollzeilenzahl}+1)\,\text{Restelementzahl} + \text{Vollzeilenzahl}\,(\text{Spaltenindex}-\text{Restelementzahl}) + \text{Zeilenindex}-1$$

auszugeben.

Die Einrichtung zum Generieren des Zeilenindex kann ausgebildet sein, um den Zeilenindex durch Abrunden eines Quotienten aus dem Eingangsindex und der Spaltenzahl zu generieren. Die Einrichtung zum Generieren des Spaltenindex kann ausgebildet sein, um den Spaltenindex durch eine Modulo-Operation des Eingangsindex mit der Spaltenzahl zu generieren. Die Einrichtung zum Generieren der Vollzeilenzahl kann ausgebildet sein, um die Vollzeilenzahl durch Abrunden eines Quotienten aus der Elementzahl und der Spaltenzahl zu generieren. Die Einrichtung zum Generieren der Restelementzahl kann ausgebildet sein, um die Restelementzahl durch eine Moduloperation der Elementzahl mit der Spaltenzahl zu generieren.

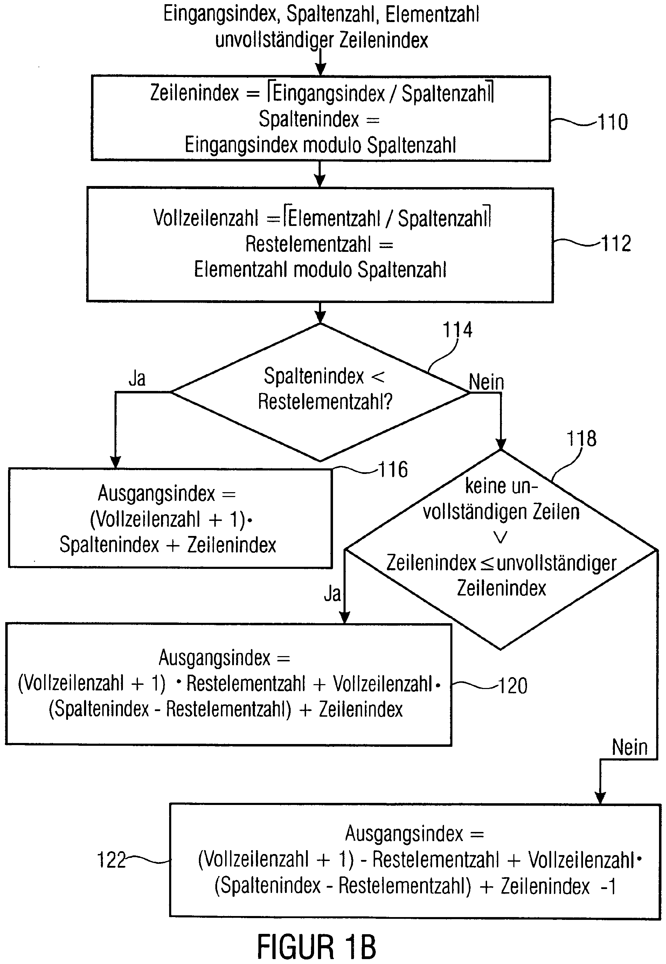

Fig. 1b zeigt ein Flussdiagramm eines Ausführungsbeispiels eines Verfahrens zum Generieren eines Ausgangsindex. Das Verfahren generiert den Ausgangsindex basierend auf einem Eingangsindex einer Spaltenzahl, einer Elementzahl und einer Information über eine unvollständige Zeile. Das Verfahren umfasst einen Schritt 110 des Generierens eines Zeilenindex basierend auf dem Eingangsindex und der Spaltenzahl. Beispielsweise kann in einem Ausführungs-beispiel der Zeilenindex als

$$\text{Zeilenindex} = \text{floor}(\text{Eingangsindex}/\text{Spaltenzahl})$$

bestimmt werden, wobei die Funktion floor(.) ein Abrunden auf die nächst geringere ganze Zahl realisiert, dies ist in der Fig. 1b durch nach unten offene Klammern angedeutet.

Der Schritt 110 umfasst ferner das Generieren eines Spaltenindex basierend auf dem Eingangsindex und der Spaltenzahl. Beispielsweise kann in einem Ausführungsbeispiel der Spaltenindex als
Spaltenindex = Eingangsindex modulo Spaltenzahl

bestimmt werden.

Das Verfahren umfasst einen Schritt 112 des Generierens einer Vollzeilenzahl basierend auf der Elementzahl und der Spaltenzahl. Beispielsweise kann in einem Ausführungsbeispiel die Vollzeilenzahl als

$$\texttt{Vollzeilenzahl = floor(Elementzahl/Spaltenzahl)}$$

bestimmt werden, wobei die Funktion floor(.) ein Abrunden auf die nächst geringere ganze Zahl realisiert, dies ist in der Fig. 1b durch nach unten offene Klammern angedeutet. Der Schritt 112 umfasst ferner das Generieren einer Restelementzahl basierend auf der Elementzahl und der Spaltenzahl. Beispielsweise kann in einem Ausführungsbeispiel die Restelementzahl als

Restelementzahl = Elementzahl modulo Spaltenzahl

bestimmt werden.

Das Verfahren umfasst mehrere Möglichkeiten des Ausgebens des Ausgangsindex, für den Fall, dass der Spaltenindex kleiner als die Restelementzahl ist, was in der Fig. 1b im Schritt 114 überprüft wird, wird der Ausgangsindex als

$$\texttt{Ausgangsindex =}$$
$$\texttt{(Vollzeilenzahl +1) Spaltenindex + Zeilenindex}$$

ausgegeben, vgl. Schritt 116 in Fig. 1b. Ansonsten wird für den Fall, dass die Information über die unvollständige Zeile angibt, dass keine unvollständige Zeile vorhanden ist oder der Zeilenindex kleiner oder gleich einem Index einer unvollständigen Zeile ist, vgl. Schritt 118 in Fig. 1b, der Ausgangsindex in Schritt 120 als

$$\texttt{Ausgangsindex =}$$
$$\texttt{(Vollzeilenzahl+1)Restelementzahl}$$
$$\texttt{+ Vollzeilenzahl(Spaltenindex-Restelementzahl)}$$
$$\texttt{+ Zeilenindex,}$$

und sonst
als

$$\texttt{Ausgangsindex =}$$
$$\texttt{(Vollzeilenzahl+1)Restelementzahl}$$
$$\texttt{+ Vollzeilenzahl(Spaltenindex-Restelementzahl)}$$
$$\texttt{+ Zeilenindex-1}$$

ausgegeben, vgl. Schritt 122.

Ausführungsbeispiele können ferner in Turbo-Kodierern und Turbo-Dekodierern eingesetzt werden.

Ausführungsbeispiele können ferner einen Rahmen-Interleaver, d.h. eine erste Interleaverstufe umfassen, die einen Fast-Rechteck-Interleaver mit mehreren Zeilen aufweist, von denen die unterste nicht vollständig ist. Die Intra-Zeilen-Interleaver, d.h. die zweite Interleaverstufe, aller Zeilen sind Linear Congruent, wobei die Lücken der letzten Zeile nicht mit interleavet werden. Die Konstante C jedes Linear Congruent Intra-Zeilen-Interleavers kann dabei einzeln einstellbar sein.

Ein Ausführungsbeispiel eines Turbo-Kode Interleavers wird im Folgenden im Detail erläutert. Das Ausführungsbeispiel basiert auf einer rekursiven Verwendung von Ausführungsbeispielen von Fast-Rechteck-Interleavern. In diesem Ausführungsbeispiel wird ein Fast-Rechteck-Interleaver sowohl als Rahmen-Interleaver als auch auf darunterliegenden Stufen für Intra- und Inter-Zeilenpermutationen verwendet.

Die zu permutierenden Informations-Bits des Informationswortes werden zunächst zeilenweise in einen Rahmen-Interleaver, d.h. in eine erste Interleaverstufe geschrieben. Im Folgenden wird der Vorsatz "Rahmen" auch weggelassen. Die erste Interleaverstufe ist in diesem Ausführungsbeispiel als ein Fast-Rechteck-Interleaver ausgebildet mit vorgegebener Anzahl Num_Bits von Bits und Spaltenzahl Num_Cols, wobei sich die Anzahl Num_Full_Rows vollständiger Zeilen und die Anzahl Num_Rem_Bits von Bits in der unvollständigen letzten Zeile aus diesen beiden Werten ergibt.

Beispielsweise könnte

Num_Bits = 22

Num_Cols = 8

→ Num_Full_Rows = 2

→ Num_Rem_Bits = 6.

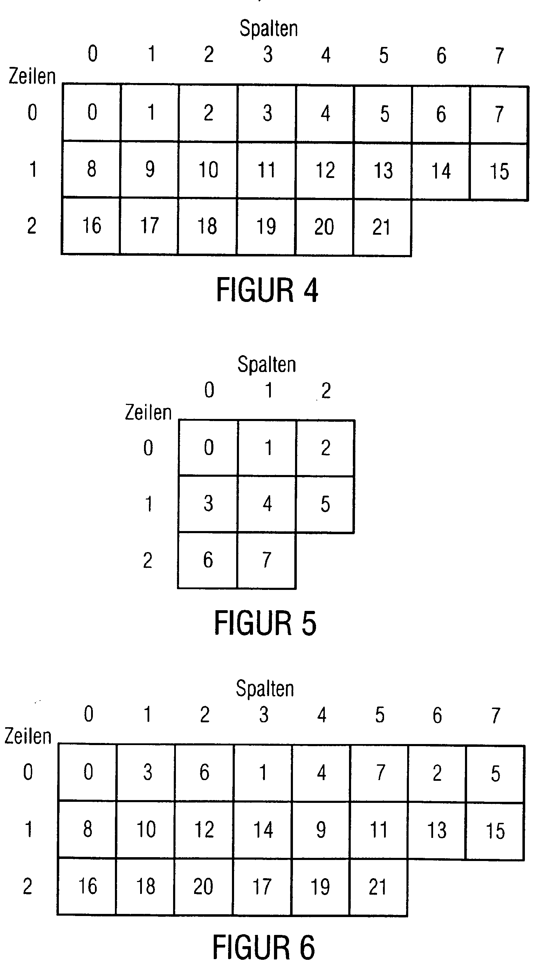

Die Fig. 4 illustriert ein Ausführungsbeispiel mit 22 Stellen, die in den Zeilen 0, 1 und 2, sowie in den Spalten 0-7 angeordnet sind. In der Fig. 4 ist zu sehen, dass die letzte Zeile nicht ganz vollständig ist, bzw. dass die Spalten 6 und 7 nur zwei Elemente aufweisen, wohingegen alle übrigen Spalten drei Elemente aufweisen. Die Elemente zeigen dabei die Ursprungspositionen der Stellen in dem Informationswort, d.h. sie können als Indizes bzw. Adressen der eigentlichen Informationswortstellen oder Elemente betrachtet werden. In der Fig. 4 ist zu erkennen, dass die erste Interleaverstufe ausgebildet ist, um die Stellen des Informationswortes zeilenweise in einer Mehrzahl von ersten Zeilen und ersten Spalten anzuordnen.

Ferner ist in der Fig. 4 zu erkennen, dass alle Zeilen Num_Cols_Bits aufweisen, nur die letzte, unvollständige Zeile beinhaltet Num_Rem_Bits, falls dieser Wert überhaupt größer als 0 ist und eine unvollständige Zeile existiert.

Die nun folgende zweite Interleaverstufe dient zum zeilenweisen Permutieren. Auch hier kommt ein Fast-Rechteck-Interleaver im vorliegenden Ausführungsbeispiel zum Einsatz. Für jede der Zeilen wird sozusagen ein Intra-Zeilen-Interleaver eingesetzt. Im Folgenden bezeichnet der Zusatz "Intra" stets Parameter, die zu einem solchen Intra-Zeilen-Interleaver, d.h. zur zweiten Interleaverstufe gehören. Die Elementzahl Num_Intra_Bits des Intra-Zeilen-Interleavers, d.h. der zweiten Interleaverstufe, ist entweder gleich Num_Cols, falls die Zeile vollständig ist oder Num_Rem_Bits für die letzte Zeile, falls sie unvollständig ist.

Die zweite Interleaverstufe ist ausgebildet zum zeilenweisen Anordnen der Elemente einer der ersten Zeilen in einer Mehrzahl von zweiten Zeilen und zweiten Spalten. Die Spaltenanzahl, die im Folgenden auch Num_Intra_Cols des Intra-Zeilen-Interleavers genannt wird, ist frei wählbar. Daraus ergeben sich die Anzahl Num_Full_Intra_Rows vollständiger Zeilen und die Zahl Num_Rem_Intra_Bits von Bits in der unvollständigen letzten Zeile. Für jede Zeile des Rahmen-Interleavers, d.h. der ersten Interleaverstufe, wird folgendes durchgeführt: Der zugehörige Intra-Zeilen-Interleaver, d.h. die zweite Interleaverstufe, wird zeilenweise geschrieben und spaltenweise ausgelesen. So wird eine permutierte Zeile, d.h. eine erste verwürfelte Zeile erhalten, die dann die entsprechende Zeile ersetzt. Um zum vorangehenden Beispiel zurückzukommen, würde beispielsweise in der ersten Zeile:

Num_Intra_Bits = Num_Cols = 8

Num_Intra_Cols = 3

→ Num_Full_Intra_Rows = 2

→ Num_Rem_Intra_Bits = 2

Zweite Zeile:

Num_Intra_Bits = Num_Cols = 8

Num_Intra_Cols = 2

→ Num_Full_Intra_Rows = 4

→ Num_Rem_Intra_Bits = 0

Dritte Zeile:

Num_Intra_Bits = Num_Rem_Bits = 6

Num_Intra_Cols = 2

→ Num_Full_Intra_Rows = 3

→ Num_Rem_Intra_Bits = 0.

Die Fig. 5 illustriert diese Vorgehensweise basierend auf dem Beispiel der Fig. 4. Die Fig. 5 zeigt die Anordnung der Indizes der ersten Zeile der ersten Interleaverstufe der Fig. 4 in zweiten Zeilen und zweiten Spalten. Die Fig. 5 zeigt, dass die Indizes der ersten Zeile der Fig. 4 nun in zweite Zeilen und zweite Spalten geschrieben wurden, in einem nächsten Schritt werden die Indizes der Fig. 5 nun spaltenweise ausgelesen und zurück in die Zeilen der Fig. 4 geschrieben. Ein solches Beispiel ist in der Fig. 6 dargestellt, die nun die verwürfelten Zeilen der Fig. 4 zeigt, die sich aus dem spaltenweisen Auslesen der zweiten Interleaverstufe der Fig. 5 ergeben. In der Fig. 6 ist gut zu erkennen, dass innerhalb jeder Zeile die Elemente lediglich verwürfelt wurden, die Zeilen untereinander jedoch nicht verwürfelt wurden.

Als nächster Schritt wird eine Inter-Zeilen-Permutation durchgeführt, anhand einer dritten Interleaverstufe. Die dritte Interleaverstufe ist ausgebildet, um die Zeilenindizes einer der ersten Zeilen zeilenweise in dritten Zeilen und dritten Spalten anzuordnen und zum spaltenweisen Auslesen der Zeilenindizes, um verwürfelte Zeilenindizes zu erhalten, und zum Vertauschen der ersten Zeilen basierend auf den verwürfelten Zeilenindizes. In anderen Worten werden hier ganze Zeilen des Rahmen-Interleavers, d.h. der ersten Interleaverstufe, miteinander vertauscht. Die Permutation zwischen diesen Zeilen wird in dem vorliegenden Ausführungsbeispiel erneut durch einen Fast-Rechteck-Interleaver beschrieben, dessen Elementzahl Num_Inter_Elems gleich der Anzahl von Zeilen, vollständig oder unvollständig, des Rahmen-Interleavers, d.h. der ersten Interleaverstufe ist, d.h. entweder Num_Full_Rows oder Num_Full_Rows + 1.

Die Spaltenanzahl Num_Inter_Cols des Inter-Zeilen-Interleavers kann jedoch frei gewählt werden, und daraus ergibt sich die Anzahl Num_Full_Inter_Rows vollständiger Zeilen und die Anzahl Num_Rem_Inter_Elems von Elementen der letzten unvollständigen Zeile, soweit vorhanden. Die Elemente des Inter-Zeilen-Interleavers sind nun nicht einzelne Stellen oder Bits, sondern ganze Zeilen, die zeilenweise geschrieben und spaltenweise gelesen werden, beispielsweise repräsentiert durch die jeweiligen Zeilenindizes.

Zurückkehrend zum obigen Beispiel würde dies bedeuten:

Num_Inter_Elems = Num_Full_Rows + 1 = 3 (eine unvollständige Zeile)

Num_Inter_Cols = 2

→ Num_Full_Inter_Rows = 1

→ Num_Rem_Inter_Elems = 1.

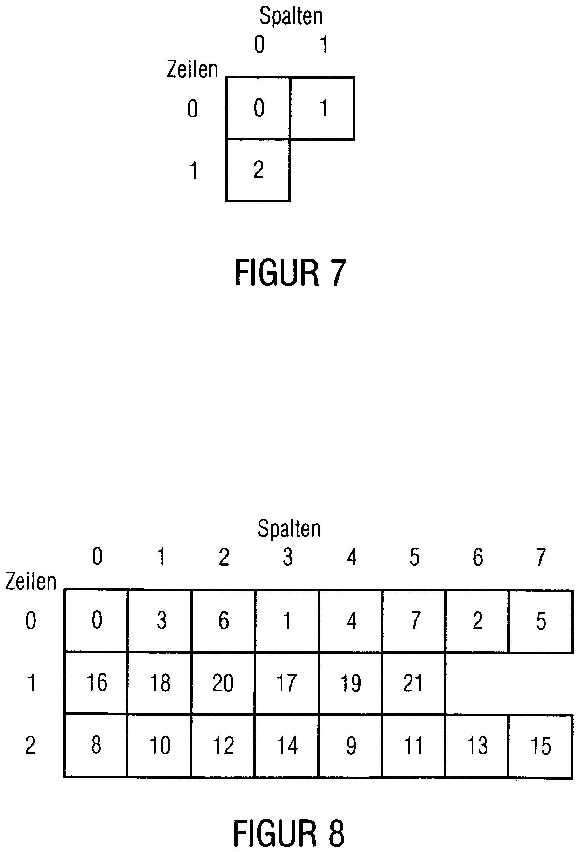

Der zugehörige Fast-Rechteck-Interleaver, d.h. die dritte Interleaverstufe des Ausführungsbeispiels, für die Inter-Zeilen-Permutation ist in der Fig. 7 dargestellt. Die Fig. 7 zeigt die Anordnung der Zeilenindizes in dritten Zeilen und dritten Spalten. In der Fig. 7 bezeichnet ein mit den "i" bezeichnetes Element eine ganze Zeile i, wie sie nach der Intra-Zeilen-Permutation, d.h. nach der zweiten Interleaverstufe, im Rahmen-Interleaver, d.h. in der ersten Interleaverstufe, steht. Die dritte Interleaverstufe mit den Zeilenindizes wird nun entsprechend spaltenweise ausgelesen, die Zeilen der ersten Interleaverstufe entsprechend umsortiert. Der Rahmen-Interleaver, d.h. die erste Interleaverstufe, wird während der Inter-Zeilen-Permutation und nach der Intra-Zeilen-Permutation wie in der Fig. 8 dargestellt, umgeordnet. Die Fig. 8 zeigt nun die erste Interleaverstufe, nach dem Zeilen- Interleaving durch die dritte Interleaverstufe.

Als letzter Schritt werden durch die erste Interleaverstufe nun basierend auf den gemäß der verwürfelten Zeilenindizes vertauschten ersten Zeilen, diese spaltenweise ausgelesen, um das permutierte Informationswort zu erhalten. In anderen Worten wird der so umgeordnete Rahmen-Interleaver spaltenweise ausgelesen, fehlende Elemente in der unvollständigen Zeile können übersprungen werden.

Die permutierten Informations-Bits werden also in der folgenden Reihenfolge des Original-Index ausgegeben: 0, 16, 8, 3, 18, 10, 6, 20, 12, 1, 17, 14, 4, 19, 9, 7, 21, 11, 2, 13, 5, 15.

An diesem Beispiel lässt sich erkennen, dass Ausführungsbeispiele des Interleavers eine Mischung aus Strukturiertheit und scheinbarer Unordnung, die an Pseudo-Zufall erinnert, darstellt, wie es beispielsweise für Turbo-Kodierer vorteilhaft ist.

Statt die Permutation wie oben beschrieben durchzuführen, in der die Informations-Bits innerhalb eines Interleavers permutiert werden, der die Elemente in einem internen Speicher enthält, kann auch ein Adressgenerator verwendet werden, der für jedes Informations-Bit am Ausgang des Turbo-Kode-Interleavers dessen Adresse bzw. Index im Eingangs-Vektor berechnet, an der dieses Bit vor der Permutation entsprechend der o.g. Vorschrift steht. Dieser Adressgenerator liefert also eine Leseadresse, so dass während des Lesens die o.g. Permutation durchgeführt wird.

Analog dazu kann in Ausführungsbeispielen auch ein Adressgenerator verwendet werden, der für jedes Informationsbit am Eingang des Interleavers, d.h. am Eingang des Ausführungsbeispiels, dessen Adresse bzw. Index im Ausgabe-Vektor berechnet, wo dieses Bit entsprechend der o.g. Vorschrift hin permutiert wird. Ausführungsbeispiele können somit Adressgeneratoren umfassen, die eine Schreibadresse liefern, so dass während des Schreibens die o.g. Permutation durchgeführt wird. Damit umfassen Ausführungsbeispiele ebenfalls entsprechende De-Interleaver.

Im Folgenden wird ein weiteres Ausführungsbeispiel betrachtet.

Für folgendes Ausführungsbeispiel gilt:

Num_Rem_Bits sei die Anzahl von Elementen in der kürzeren (unvollständigen) Zeile (0 falls nicht vorhanden). Num_Full_Rows sei die Anzahl von vollständigen Zeilen. Short_Row_Idx (gezählt ab 0) sei der Zeilen-Index der kürzeren Zeile nach der Inter-Zeilen-Permutation. Falls keine unvollständige Zeile vorhanden ist, ist Short_Row_Idx = Num_Full_Rows (d.h. ein nicht vorhandener Zeilen-Index).

Es wird ein Element i des Informationswortes am Eingang des Interleavers betrachtet, wobei die Adresse berechnet werden soll, an die es durch den Interleave-Vorgang im Speicher geschrieben werden soll (d.h. in der 1. Komponente war dieses Element in Position i und berechnet wird die Position in der 2. Komponente).

Ilvd_Col_Idx (gezählt ab 0) sei der Spalten-Index nach der Intra-Zeilen-Permutation.

Ilvd_Row_Idx (gezählt ab 0) sei der Zeilen-Index nach der Inter-Zeilen-Permutation.

Dann lässt sich eine Berechnungsvorschrift der Adresse des interleaveten Elements i angeben:

```
if (Ilvd_Col_Idx < Num_Rem_Bits) {
// es existiert zwar eine unvollständige Zeile, aber in
// dieser Spalte hat sie noch keine fehlenden Elemente
   Addr = (Num_Full_Rows+1)*Ilvd_Col_Idx + Ilvd_Row_Idx;
   }
   else {
   // es existiert keine unvollständige Zeile,
   // oder in der aktuellen Spalte stehen fehlende
   // Elemente der unvollständigen Zeile
   if (Ilvd_Row_Idx < Short_Row_Idx) {
   // Zeile liegt oberhalb der unvollständigen Zeile
   //(oder es existiert keine unvollständige Zeile)
      Addr = (Num_Full_Rows+1)*Num_Rem_Bits +
         Num_Full_Rows *(Ilvd_Col_Idx-Num_Rem_Bits) +
         Ilvd_Row_Idx;
    }
   else {
   // es existiert eine unvollständige Zeile und die
   // aktuelle Zeile liegt unterhalb davon
      Addr = (Num_Full_Rows+1)*Num_Rem_Bits +
         Num_Full_Rows *(Ilvd_Col_Idx-Num_Rem_Bits) +
          (Ilvd_Row_Idx-1);
    }
 }
```

Mit dem oben aufgeführten Ausführungsbeispiel ist es also möglich, für ein Element mit Index i am Eingang des Interleavers eine Schreibadresse unmittelbar zu berechnen, d.h. ohne Hinzufügen, Verarbeiten und Entfernen von Dummy-Bits und ohne die Erzeugung von ggf. ungültigen Kandidaten-Adressen. Ausser der o.a. Berechnungsvorschrift werden lediglich die Vorschriften zur Berechnung von Ilvd_Col_Idx und Ilvd_Row_Idx aus der Position i benötigt, die unmittelbar aus der Definition von Fast-Rechteck-Interleavern angebbar ist.

In dem Folgenden Ausführungsbeispiel wird auch die Bestimmung der Zeilen- und Spaltenindizes im Detail erläutert. Das Ausführungsbeispiel umfasst einen Indexgenerator zum Generieren eines Ausgangsindex basieren auf einem Eingangsindex. In dem folgenden Ausführungsbeispiel wird für einen wahlfreien Bit-Index (Eingangsindex) dessen Schreib-Adresse erzeugt (Ausgangsindex). Diese Berechnung wird als Abfolge von Rechen-Schritten angegeben. Außerdem ist eine rekursive Verwendung derselben Funktionen (Fast_Rect_Write_To_2D() und Fast_Rect_Read_From_2D()) sowohl für die Rahmen- als auch die Intra- und Inter-Zeilen-Permutation in weiteren Ausführungsbeispielen denkbar. Zudem wird für jeden gültigen Bit-Index eine gültige Schreibadresse erzeugt, so dass keinerlei Signalisierung über die Gültigkeit der erzeugten Schreibadresse nötig ist.

Für den äquivalenten Vorgang, dass der Indexgenerator für einen Bit-Index der zweiten Komponente Lese-Adressen erzeugen soll, so dass während des Lesens eines externen Speichers das Interleaving bzw. die Verwürfelung erfolgt, lässt sich ebenso in Form eines geschlossenen Programmes angeben, bei dem keine ungültigen Lese-Adressen erzeugt werden und kann analog erfolgen.

Ausführungsbeispiel können eine besonders aufwandsgünstige Implementierung aufweisen, wenn die Schreib- oder Lese-Adressen sequentiell erzeugt werden, d.h. wenn die Eingangsvariable, nämlich der Bit-Index der 1. bzw. 2. Komponente, immer in Schritten von 1 erhöht wird. Insbesondere kann in diesen Ausführungsbeispielen die Berechnung des abgerundeten Quotienten und des Restes bei allen Divisionen eingespart werden.

Im folgenden wird das Ausführungsbeispiel für einen Generator zur Erzeugung von Schreib-Adressen (Ausgangsindex) für einen wahlfreien Index eines Bits (Eingangsindex) vor dem Interleaven angegeben. Ein Schreiben dieses Bits in die erzeugte Adresse ist äquivalent zum Interleaven des Bits für die eingestellten Interleaver-Parameter. Das Ausführungsbeispiel ist in der Notation der Sprache Matlab abgefasst.

```
function Write_Addr = Proposed_Ilv(In_Idx)
% Erzeuge Schreibadresse (Ausgangsindex) in externes Memory
% für einen wahl freien Bit-Index
% In_Idx (Eingangsindex = Index des Bits vor dem Interlea-
% ven), so dass ein derartiges Schreiben äquivalent zum In-
% terleaven dieses
% Bits ist.
% Parametrierung dieses Interleavers:
% Elementzahl = Anzahl Bits im Rahmen-Interleaver
Num_Bits = 22;
% Spaltenzahl = Anzahl Spalten im Rahmen-Interleaver
Num_Cols = 8;
% Anzahl (Intra-)Spalten jedes einzelnen Intra-Zeilen-
% Interleavers
Num_Intra_Cols_LUT = [3 2 2];
% Anzahl (Inter-)Spalten im Inter-Zeilen-Interleaver
Num_Inter_Cols = 2;
% Vollzeilenzahl = Anzahl vollständiger Zeilen im Rahmen-
% Interleaver
Num_Full_Rows = floor(Num_Bits / Num_Cols);
% Gesamt-Anzahl Zeilen im Rahmen-Interleaver
Num_Rows = ceil(Num_Bits / Num_Cols);
% Anzahl von Bits in unvollständiger (letzter) Zeile
Num_Rem_Bits = mod(Num_Bits,Num_Cols);
% Rahmen-Interleaver
% Umwandlung Bit-Index in Zeilenindex und Spaltenindex
% beim zeilenweisen Schreiben
[Row_Idx,Col_Idx] = Fast_Rect_Write_To_2D(In_Idx,Num_Cols);
% Anzahl von (Intra-)Bits in dieser Zeile
if (Row_Idx < Num_Full_Rows)
    % vollständige Zeile
    Num_Intra_Bits = Num_Cols;
    else
    % unvollständige Zeile
    Num_Intra_Bits = Num_Rem_Bits;
    end
    % Intra-Zeilen-Permutation
    % Umwandlung auf (Intra-) Zeilen-/Spaltenindex beim zeilen-
    weisen Schreiben
    [Intra_Row_Idx,Intra_Col_Idx]
    = Fast_Rect_Write_To_2D(Col_Idx,
    Num_Intra_Cols_LUT(Row_Idx+1));
    % Row_Idx +1 da Matlab-Indizes mit 1 starten
    % Umwandlung von (Intra-) Zeilen-/Spaltenindex beim spal-
    tenweisen Lesen
    Ilvd_Col_Idx = Fast_Rect_Read_From_2D(Intra_Row_Idx,
            Intra_Col_Idx,Num_Intra_Bits,
```

```
                Num_Intra_Cols_LUT(Row_Idx +1), 0, 0);
                % Row_Idx +1 da Matlab-Indizes mit 1 starten
                % Inter-Zeilen-Permutation
                % Umwandlung auf (Inter-) Zeilen-/Spalten-Index beim zei
                % lenweisen Schreiben
    [Inter_Row_Idx,Inter_Col_Idx]=
        Fast_Rect_Write_To_2D(Row_Idx, Num_Inter_Cols);
        % Umwandlung von (Inter-) Zeilen-/Spaltenindex beim spal-
        % tenweisen Lesen
        Ilvd_Row_Idx = Fast_Rect_Read_From_2D(Inter_Row_Idx,
                Inter_Col_Idx, Num_Rows,
                Num_Inter_Cols, 0, 0);
                % Bestimmung der Position der unvollständigen Zeile nach
                % der Inter-Zeilen-Permutation (analog zu Inter-Zeilen-
                % Permutation)
    [Inter_Row_Idx,Inter_Col_Idx]
                = Fast_Rect_Write_To_2D(Num_Rows-1,
                  Num_Inter_Cols);
                  Incompl_Row_Idx = Fast_Rect_Read_From_2D(Inter_Row_Idx,
                  Inter_Col_Idx,Num_Rows, Num_Inter_Cols,
                  0, 0);
                % Umwandlung von neuem Zeilen-/Spalten-Index beim spalten-
                % weisen Lesen in äquivalente Schreib-Adresse
                  Write_Addr =
                Fast_Rect_Read_From_2D(Ilvd_Row_Idx,
                Ilvd_Col_I dx, Num_Bits, Num_Cols, 1,
                Incompl_Row_Idx);
                end
                % Fast-Rechteck-Interleaving
                % Umwandlung von Element-Index in Zeilen-/Spalten-Index
                % beim zeilenweisen Schreiben für Num_Cols Spalten
                function [Row_Idx, Col_Idx] =
            Fast_Rect_Write_To_2D(Write_Idx,Num_Cols)
            Row_Idx = floor(Write_Idx / Num_Cols);
            Col_Idx = mod(Write_Idx, Num_Cols);
            end
            % Fast-Rechteck-Interleaving
            % Umwandlung von Zeilen-/Spalten-Index beim spaltenweisen
            % Lesen in Element-Index bei insgesamt Num_Elems Elementen,
            % Num_Cols Spalten.
            % Falls eine unvollständige Zeile inmitten des Fast-
            % Rechteck-Interleavers liegt, muss Incompl_Row_Inside_Flag
            % = 1 sein und Incompl_Row_Idx deren Zeilen-Index angeben.
            function [Read_Idx] =
        Fast_Rect_Read_From_2D(Row_Idx, Col_Idx, Num_Elems,
        Num_Cols, Incompl_Row_Inside_Flag, Incompl_Row_Idx)
        % Anzahl vollständiger Zeilen
        Num_Full_Rows = floor(Num_Elems / Num_Cols);
        % Anzahl Elemente in unvollständiger Zeile
        Num_Rem_Elems = mod(Num_Elems,Num_Cols);
        % Spaltenindex < Restelementzahl
        if (Col_Idx < Num_Rem_Elems)
        % es existiert zwar eine unvollständige Zeile, aber in
        % dieser Spalte hat sie noch keine fehlenden Elemente
        Read_Idx = (Num_Full_Rows+1)*Col_Idx + Row_Idx;
        else
        % es existiert keine unvollständige Zeile,
        % oder in der aktuellen Spalte stehen fehlende
        % Elemente der unvollständigen Zeile
        if (Incompl_Row_Inside_Flag == 0
                || Row_Idx <= Incompl_Row_Idx)
            % Zeile liegt oberhalb der unvollständigen Zeile
            % (oder es existiert keine unvollständige Zeile)
```

```
        Read_Idx = (Num_Full_Rows+1)*Num_Rem_Elems
                + Num_Full_Rows *(Col_Idx-Num_Rem_Elems)
                + Row_Idx;
    else
        % es existiert eine unvollständige Zeile und die
        % aktuelle Zeile liegt unterhalb davon
        Read_Idx = (Num_Full_Rows+1)*Num_Rem_Elems
                +Num_Full_Rows *(Col_Idx-Num_Rem_Elems)
                + (Row_Idx-1);
    end
    end
    end
```

In einem weiteren Ausführungsbeispiel, werden die Parameter wie folgt gewählt:

Num_Bits = 1146

Num_Cols = 191

Num_Full_Rows = 6

Num_Rem_Bits = 0 (keine unvollständigen Zeilen)
→ für alle 6 Zeilen ist Num_Intra_Bits = 191;

Die anderen Parameter ergeben sich dann wie in der folgenden Tabelle angegeben, die die Struktur dieses Turbo Kode Interleavers zeigt:

| Zeilen-Index | Num_Intra_Cols | Num_Full_Intra_Rows | Num_Rem_Intra_Bits |
|---|---|---|---|
| 0 | 17 | 11 | 4 |
| 1 | 12 | 15 | 11 |
| 2 | 26 | 7 | 9 |
| 3 | 37 | 5 | 6 |
| 4 | 14 | 13 | 9 |
| 5 | 21 | 9 | 2 |

In einem weiteren Ausführungsbeispiel, werden die Parameter wie folgt gewählt:

Num_Bits = 12282

Num_Cols = 2047

Num_Full_Rows = 6

Num_Rem_Bits = 0 (keine unvollständigen Zeilen)
→ für alle 6 Zeilen ist Num_Intra_Bits = 2047;

Die anderen Parameter ergeben sich dann wie in der folgenden Tabelle angegeben, die die Struktur dieses Turbo Kode Interleavers zeigt:

| Zeilen-Index | Num_Intra_Cols | Num_Full_Intra_Rows | Num_Rem_Intra_Bits |
|---|---|---|---|
| 0 | 39 | 52 | 19 |
| 1 | 54 | 37 | 49 |
| 2 | 30 | 68 | 7 |

(fortgesetzt)

| Zeilen-Index | Num_Intra_Cols | Num_Full_Intra_Rows | Num_Rem_Intra_Bits |
|---|---|---|---|
| 3 | 47 | 43 | 26 |
| 4 | 66 | 31 | 1 |
| 5 | 35 | 58 | 17 |

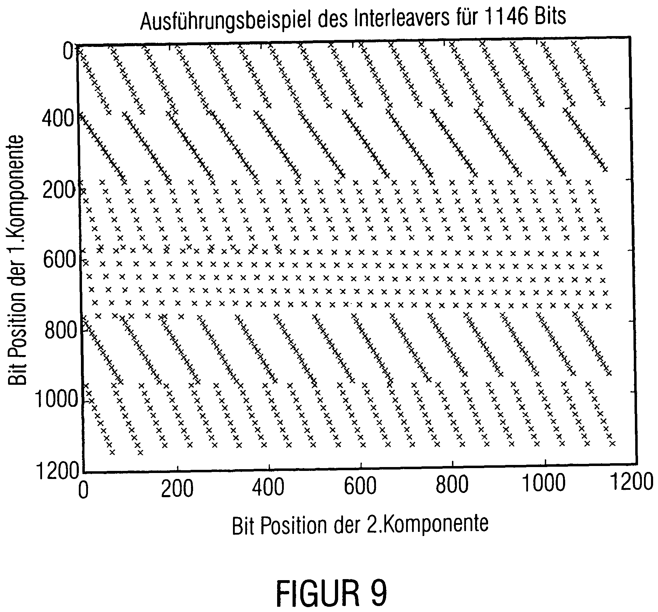

Fig. 9 zeigt ein Schaubild der Zuordnung der Positionen der ersten und zweiten Komponente für ein Ausführungsbeispiel mit einer Blocklänge von 1146 Bits. Die dort gezeigte Permutation eines Ausführungsbeispiels entspricht einer rekursiven Verwendung von Fast-Rechteck-Interleavern in den drei Interleaverstufen.

Die Fig. 10a zeigt Simulationsergebnisse für Wortfehlerraten WER (WER = word error rate) über Eb/N0 in dB, d.h. Bitenergie Eb über Rauschleistungsdichte N0. Die Simulationsergebnisse sind für drei verschiedene Interleaver im Zusammenspiel mit dem oben betrachteten Turbo-Kodierer bzw. Turbo-Dekodierer angegeben für eine Wortlänge von 1146 Bits. Die obere Kurve, die mit der gestrichelten Linie angegeben und mit "Zufalls-Interleaver" bezeichnet ist, wurde mit einem Zufalls-Interleaver erzeugt. Die zweite Kurve, die mit einer strichpunktierten Linie angegeben ist, entspricht einem einzelnen Fast-Rechteck-Interleaver und ist mit "Fast-Rechteck-Interleaver" bezeichnet. Die mit dem oben beschriebenen Ausführungsbeispiel der drei Interleaverstufen erreichte Kurve ist mit einer durchgezogenen Linie angegeben und mit "Ausführungsbeispiel" bezeichnet.

Die Fig. 10a zeigt die Leistungsfähigkeit eines Pseudo-Zufalls-Interleavers und eines einfachen Fast-Rechteck-Interleavers in der Länge 1146 mit 34 Spalten, sowie die WER-Kurve des oben vorgestellten Interleavers. Verwendet wird jeweils ein Turbo-Kode-Interleaver mit einer Koderate von 1/2 mit Komponentenkodes der Gedächtnislänge 3. Wie erkennbar ist, ist die Leistungsfähigkeit des Ausführungsbeispiels deutlich besser als die der beiden anderen Turbo-Kode-Interleaver. Auch ist im Gegensatz zu den anderen beiden Interleavern kein deutlicher Error Floor erkennbar, was den Vorteil des Ausführungsbeispiels gegenüber den herkömmlichen Interleavern deutlich herausstellt.

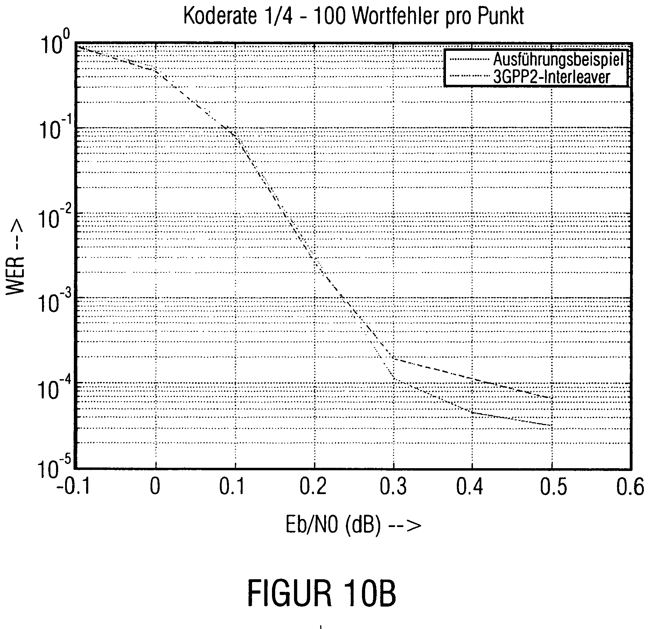

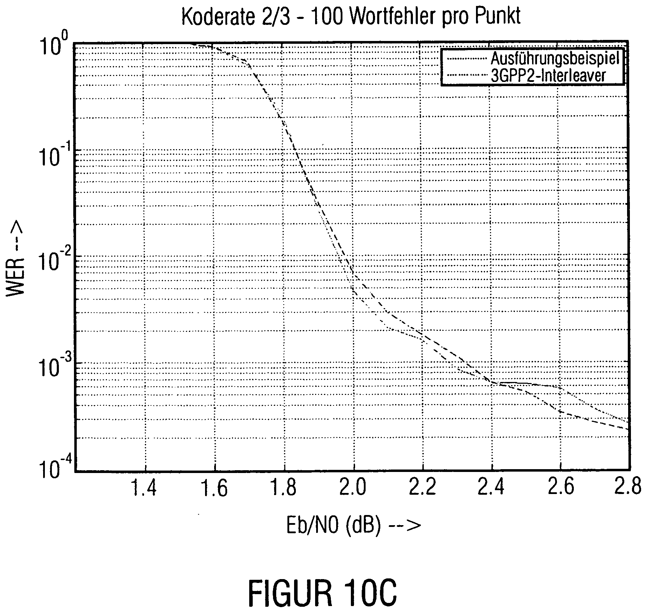

Fig. 10b zeigt Simulationsergebnisse zum Vergleich eines Ausführungsbeispiels mit einem 3GPP2 Interleaver anhand deren Wortfehlerraten (WER). Der Kurvenverlauf der WER für das Ausführungsbeispiel ist mit "Ausführungsbeispiel" bezeichnet, der Verlauf der WER des 3GPP2-Interleavers ist mit "3GPP2 ilv." bezeichnet. Der Vergleich wurde dabei für eine Koderate von 1/4 durchgeführt. In der Fig. 10b ist deutlich zu erkennen, dass das Ausführungsbeispiel einen deutlich niedrigeren Error Floor erzeugt. Das Ausführungsbeispiel liefert einen um ca. Faktor 2 niedrigeren Error Floor bzw. liefert 0.2dB Gewinn in SNR für die gleiche WER. Fig. 10c zeigt weitere Simulationsergebnisse zum Vergleich eines Ausführungsbeispiels mit einem 3GPP2 Interleaver in der gleichen Darstellung, wie sie bereits anhand der Fig. 10b erläutert wurde. Die Fig. 10c zeigt einen Vergleich bei einer Koderate von 2/3. Das Ausführungsbeispiel ist dabei in etwa so gut wie der 3GPP2-Interleaver, im Arbeitspunkt WER = 2*10-3 kann er ca. 0.1dB in SNR gegenüber dem 3GPP2 gewinnen. Es lässt sich demnach erkennen, dass sowohl für sehr niedrige, wie auch für hohe Coderaten, Ausführungsbeispiele mindestens so gut wie der 3GPP2 sind und dessen Leistungsfähigkeit sogar übertreffen.

Ausführungsbeispiele bieten gegenüber dem 3GPP2-Interleaver ferner Vorteile hinsichtlich der flexiblen Konfigurierbarkeit. Die Verwendung einer Linear Congruent Permutation (3GPP2-Interleaver) für das Intra-Zeilen-Interleaving erlaubt nicht beliebige Inkremente (Konstante C bei Linear Congruent-Berechnungsvorschrift), sondern nur diejenigen, die relativ prim zur Interleaverlänge sind. Ausführungsbeispiele eines Fast-Rechteck-Interleavers erlauben hingegen immer eine freie Wahl der Anzahl von Spalten, so dass auch für die Anzahl von Zeilen eine große Auswahl zur Verfügung steht. Aufgrund der größeren Wahlfreiheit besteht hier ein höheres Potenzial, geeignete Parameter für eine gute Leistungsfähigkeit zu finden.

Ausführungsbeispiele bieten ferner den Vorteil, dass sie mit weniger Aufwand implementierbar sind. Beispielsweise beim 3GPP2-Interleaver werden Kandidaten-Adressen erzeugt, die manchmal ungültig sind. Somit erfordern diese Interleaver eine spezielle Strategie, um in jedem Taktzyklus mit Sicherheit eine gültige Adresse zu erhalten, vgl. z.B. Steven J. Halter, "Random-Access Multi-Directional CDMA2000 Turbo Code Interleaver", US Patent 6 871 303 B2, 2001. Hierfür werden in jedem Taktzyklus zwei Kandidaten-Adressen erzeugt. Deshalb ist eine Rückkopplung von einem Teil des Algorithmus, der die Gültigkeit überprüft, zu einem anderen Teil nötig, welcher den Counter erhöht und darauf basierend diese zwei Kandidaten-Adressen erzeugt.

Beim Ausführungsbeispielen von Fast-Rechteck-Interleavern kommen keine ungültigen Kandidaten-Adressen vor, der Algorithmus benötigt keinerlei Feedback und kann optimal gepipelined werden, d.h. er kann sequentiell ausgeführt werden und es sind keine Rückkopplungen erforderlich. Deshalb können Ausführungsbeispiele durch diese Berechnungsvorschrift prinzipiell höhere Taktraten der Schaltung ermöglichen als beispielsweise der 3GPP2-Algorithmus. Ausführungsbeispiele bieten somit den Vorteil, dass gute Leistungsfähigkeit bei geringer Komplexität und geringem Speicherbedarf bereitgestellt werden kann.

Insbesondere wird darauf hingewiesen, dass abhängig von den Gegebenheiten das erfindungsgemäße Schema auch in Software implementiert sein kann. Die Implementation kann auf einem digitalen Speichermedium, insbesondere einer Diskette, einem Flash-Speicher, einer CD oder einer DVD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt, kann die Erfindung somit als ein Computerprogramm mit einem Programmkode zur Durchführung des Verfahrens realisiert werden, wenn das Computerprogrammprodukt auf einem Computer abläuft.

**Bezugszeichenliste**

| | |
|---|---|
| 1100 | Turbo-Kodierer |
| 1105 | erster Komponenten-Kodierer |
| 1110 | Turbo-Kode-Interleaver |
| 1115 | zweiter Komponenten-Kodierer |
| 1120 | Punktierer |
| 1200 | Flip-Flop |
| 1205 | Flip-Flop |
| 1210 | Flip-Flop |
| 1215 | Eingang |
| 1220 | Ausgang |
| 1225 | Ausgang |
| 1230 | Rückkoppelzweig |
| 1300 | Depunktierer |
| 1305 | erster Komponenten-Dekodierer |
| 1310 | zweiter Komponenten-Dekodierer |
| 1315 | Turbo-Kode-Interleaver |
| 1320 | Turbo-Kode-De-Interleaver |

**Patentansprüche**

1.  Interleaver zum Verwürfeln eines Informationswortes, wobei das Informationswort eine Vielzahl von Stellen aufweist, um ein permutiertes Informationswort zu erhalten, mit folgenden Merkmalen:

    einer ersten Interleaverstufe zum zeilenweisen Anordnen der Stellen des Informationswortes in einer Mehrzahl von ersten Zeilen und ersten Spalten, wobei eine letzte der ersten Zeilen unvollständig ist und zumindest in einer letzten der ersten Spalten eine Lücke aufweist; und
    einer zweiten Interleaverstufe zum Verwürfeln der Stellen der ersten Zeilen inklusive der letzten Zeile mit mindestens der Lücke in der letzten ersten Spalte durch Vertauschen wenigstens zweier Stellen der jeweiligen ersten Zeile, und zwar so, dass bei der letzten ersten Zeile eine Position der Lücke unverändert bleibt, um erste verwürfelte Zeilen zu erhalten, und zum Ersetzen der ersten Zeilen mit den ersten verwürfelten Zeilen;
    einer dritten Interleaverstufe zum Durchführen einer Inter-Zeilen-Permutation an den ersten Zeilen nach Ersetzung derselben durch die verwürfelten Zeilen;
    wobei die erste Interleaverstufe ausgebildet ist, um die ersten Spalten nach der Inter-Zeilen-Permutation spaltenweise mittels einer Berechnungsvorschrift auszulesen und die Stellen der ersten Spalten lückenlos aneinander zu reihen, um das permutierte Informationswort zu erhalten,
    wobei der Interleaver ausgebildet ist, die Berechnungsvorschrift zu verwenden, um eine Adresse Addr in dem permutierten Informationswort für eine Stelle in einer ersten Zeile mit einem Spaltenindex Ilvd_Col_Idx nach Verwürfelung der Stellen der ersten Zeilen und einem Zeilenindex Ilvd_Row_Idx nach Inter-Zeilen-Permutation zu erhalten, wobei Short_Row_Idx den Zeilenindex der unvollständigen ersten Zeile nach Inter-Zeilen-Permutation ist, Num_Rem_Bits eine Anzahl an Stellen in der unvollständigen Zeile ist, und Num_Full_Rows die Anzahl an vollständigen ersten Zeilen ist, und die Berechnungsvorschrift lautet:

    falls Ilvd_Col_Idx kleiner Num_Rem_Bits ist,
    Berechne Addr zu (Num_Full_Rows+1)*Ilvd_Col_Idx + Ilvd_Row_Idx;

falls Ilvd_Col_Idx nicht kleiner Num_Rem_Bits ist und

Ilvd_Row_Idx kleiner Short_Row_Idx,

Berechne Addr zu (Num_Full_Rows+1)*Num_Rem_Bits + Num_Full_Rows * (Ilvd_Col_Idx-Num_Rem_Bits) + Ilvd_Row_Idx;

falls Ilvd_Col_Idx nicht kleiner Num_Rem_Bits ist und

Ilvd_Row_Idx nicht kleiner Short_Row_Idx,

Berechne Addr zu (Num_Full_Rows+1)*Num_Rem_Bits + Num_Full_Rows *(Ilvd_Col_Idx-Num_Rem_Bits) + Ilvd_Row_Idx.

2. Interleaver gemäß Anspruch 1, bei dem die zweite Interleaverstufe ausgebildet ist, um die Stellen der einen ersten Zeile durch eine linear congruente Interleaver-Regel zu Verwürfeln, so dass eine Position der Lücke unverändert bleibt, um die erste verwürfelte Zeile zu erhalten, und zum Ersetzen der einen der ersten Zeilen mit der ersten verwürfelten Zeile.

3. Interleaver gemäß einem der Ansprüche 1 oder 2, bei dem
die zweite Interleaverstufe ausgebildet ist, zum zeilenweisen Anordnen der Stellen einer der ersten Zeilen in einer Mehrzahl von zweiten Zeilen und zweiten Spalten, und zum spaltenweisen Auslesen der Stellen um eine erste verwürfelte Zeile zu erhalten, und zum Ersetzen der einen der ersten Zeilen mit der ersten verwürfelten Zeile, wobei die erste Interleaverstufe ausgebildet ist, um die basierend auf der ersten verwürfelten Zeile ersetzte erste Zeile spaltenweise und lückenlos auszulesen, um das permutierte Informationswort zu erhalten, und/oder
die dritte Interleaverstufe ausgebildet ist, zum zeilenweisen Anordnen von Zeilenindizes der ersten Zeilen in dritten Zeilen und dritten Spalten, und zum spaltenweisen Auslesen der Zeilenindizes um verwürfelte Zeilenindizes zu erhalten und zum Vertauschen der ersten Zeilen basierend auf den verwürfelten Zeilenindizes, wobei die erste Interleaverstufe ausgebildet ist, um die basierend auf den verwürfelten Zeilenindizes vertauschten ersten Zeilen spaltenweise und lückenlos auszulesen, um das permutierte Informationswort zu erhalten.

4. Interleaver gemäß einem der Ansprüche 1 bis 3, wobei
die zweite Interleaverstufe ausgebildet ist, um die Stellen der einen ersten Zeile in einer Anzahl von zweiten Zeilen und einer Anzahl von zweiten Spalten anzuordnen, wobei die eine erste Zeile eine Anzahl von Stellen aufweist, die kleiner als das Produkt aus der Anzahl von zweiten Zeilen und der Anzahl von zweiten Spalten ist, und die zweite Interleaverstufe ferner ausgebildet ist, um beim spaltenweisen Auslesen auftretende Lücken zu überspringen.

5. Interleaver gemäß einem der Ansprüche 1 bis 4, wobei
die erste, zweite und/oder dritte Interleaverstufe ausgebildet ist, um ein Informationswort zu verarbeiten, bei dem jede Stelle eine Binärstelle umfasst.

6. Interleaver gemäß einem der Ansprüche 1 bis 5, wobei
die dritte Interleaverstufe ausgebildet ist, um die Zeilenindizes in einer Anzahl von dritten Zeilen und einer Anzahl von dritten Spalten anzuordnen, wobei die Anzahl der Zeilenindizes kleiner ist als das Produkt aus der Anzahl von dritten Zeilen und der Anzahl von dritten Spalten und die dritte Interleaverstufe ferner ausgebildet ist, um beim spaltenweisen Auslesen auftretende Lücken zu überspringen.

7. Interleaver gemäß einem der Ansprüche 1 bis 6, bei dem
die erste, zweite und/oder dritte Interleaverstufe ausgebildet ist, um als Informationswort einen Vektor von Lese- oder Schreibadressen zu verwürfeln.

8. Verfahren zum Verwürfeln eines Informationswortes, wobei das Informationswort eine Vielzahl von Stellen aufweist, um ein permutiertes Informationswort zu erhalten, mit folgenden Schritten
zeilenweises Anordnen der Stellen des Informationswortes in einer Mehrzahl von ersten Zeilen und ersten Spalten, wobei eine letzte der ersten Zeilen unvollständig ist und zumindest in einer letzten der ersten Spalten eine Lücke aufweist; und
Verwürfeln der Stellen der ersten Zeilen inklusive der letzten Zeile mit mindestens der Lücke in der letzten ersten Spalte durch Vertauschen wenigstens zweier Stellen der jeweiligen ersten Zeile, und zwar so, dass bei der letzten ersten Zeile eine Position der Lücke unverändert bleibt, um erste verwürfelte Zeilen zu erhalten;
Ersetzen der ersten Zeilen mit den ersten verwürfelten Zeilen;
Durchführen einer Inter-Zeilen-Permutation an den ersten Zeilen nach Ersetzung derselben durch die verwürfelten Zeilen;
spaltenweises Auslesen der ersten Spalten nach der Inter-Zeilen-Permutation mittels einer Berechnungsvorschrift und Aneinanderreihen der Stellen der ersten Spalten lückenlos, um das permutierte Informationswort zu erhalten; und Verwenden der Berechnungsvorschrift, um eine Adresse Addr in dem permutierten Informationswort für eine Stelle in einer ersten Zeile mit einem Spaltenindex Ilvd_Col_Idx nach Verwürfelung der Stellen der ersten Zeilen und einem Zeilenindex Ilvd_Row_Idx nach Inter-Zeilen-Permutation zu erhalten, wobei Short_Row_Idx den Zeilenindex der unvollständigen ersten Zeile nach Inter-Zeilen-Permutation ist, Num_Rem_Bits eine Anzahl an Stellen in der unvollständigen Zeile ist, und Num_Full_Rows die Anzahl an vollständigen ersten Zeilen ist, und die Berechnungsvorschrift lautet:

falls Ilvd_Col_Idx kleiner Num_Rem_Bits ist, Berechne Addr zu (Num_Full_Rows+1)*Ilvd_Col_Idx + Ilvd_Row_Idx;
falls Ilvd_Col_Idx nicht kleiner Num_Rem_Bits ist und
Ilvd_Row_Idx kleiner Short_Row_Idx,
Berechne Addr zu (Num_Full_Rows+1)*Num_Rem_Bits + Num_Full_Rows * (Ilvd_Col_Idx-Num_Rem_Bits) + Ilvd_Row_Idx;
falls Ilvd_Col_Idx nicht kleiner Num_Rem_Bits ist und
Ilvd_Row_Idx nicht kleiner Short_Row_Idx,
Berechne Addr zu (Num_Full_Rows+1)*Num_Rem_Bits + Num_Full_Rows *(Ilvd_Col_Idx-Num_Rem_Bits) + Ilvd_Row_Idx.

9. Computerprogramm mit einem Programmkode zur Durchführung eines der Verfahrens gemäß Anspruch 8, wenn der Programmkode auf einem Prozessor ausgeführt wird.

10. Turbo-Kodierer oder -Dekodierer mit einem Interleaver gemäß einem der Ansprüche 1 bis 7.

**Claims**

1. An interleaver for scrambling an information word, the information word comprising a plurality of digits, in order to obtain a permuted information word, comprising:

a first interleaver stage for a row-by-row arranging of the digits of the information word in a plurality of first rows and first columns, a last of the first rows being incomplete and having a gap in at least a last of the first columns; and
a second interleaver stage for scrambling the digits of the first rows including the last row having at least the gap in the last first column by interchanging at least two digits of the respective first row, such that in the last first row a position of the gap remains unchanged in order to obtain first scrambled rows, and for replacing the first rows by the first scrambled rows;
a third interleaver stage for performing inter-row-permutation at the first rows after replacing the same by the scrambled rows;
wherein the first interleaver stage is configured for reading the first columns after the inter-row-permutation in a column-by-column manner using a calculation regulation, and lining the digits of the first columns up without gaps in order to obtain the permuted information word,
wherein the interleaver is configured to use the calculation regulation in order to obtain an address Addr in the permuted information word for a digit in a first row with a column index Ilvd_Col_Idx after scrambling the digits of the first rows and with a row index Ilvd_Row_Idx after inter-row permutation, wherein Short_Row_Idx is the row index of the incomplete first row after inter-row permutation, Num_Rem_Bits is a number of digits in the incomplete row, and Num_Full_Rows is the number of complete first rows, and the calculation regulation is:

if Ilvd_Col_Idx is smaller than Num_Rem_Bits,
calculate Addr to be equal to (Num_Full_Rows+ 1) * Ilvd_Col_Idx + Ilvd_Row_Idx;
if Ilvd_Col_Idx is not smaller than Num_Rem_Bits and Ilvd_Row_Idx is smaller than Short_Row_Idx,
calculate Addr to be equal to (Num_Full_Rows+ 1) * Num_Rem_Bits + Num_Full_Rows * (Ilvd_Col_Idx - Num_Rem_Bits) + Ilvd_Row_Idx;
if Ilvd_Col_Idx is not smaller than Num_Rem_Bits and Ilvd_Row_Idx is not smaller than Short_Row_Idx,
calculate Addr to be equal to (Num_Full_Rows+ 1) * Num_Rem_Bits + Num_Full_Rows * (Ilvd_Col_Idx - Num_Rem_Bits) + Ilvd_Row_Idx.

2. The interleaver of claim 1, wherein the second interleaver stage is configured for scrambling the digits of the one first row by a linear congruent interleaver rule such that a position of the gap remains unchanged in order to obtain the first scrambled row, and for replacing the one of the first rows by the first scrambled row.

3.  The interleaver of claims 1 or 2, wherein
    the second interleaver stage is configured for a row-by-row arranging of the digits of one of the first rows in a plurality of second rows and second columns, and for the column-by-column reading of the digits in order to obtain a first scrambled row, and for replacing the one of the first rows by the first scrambled row, wherein the first interleaver stage is configured for reading the first row, which is replaced based on the first scrambled row, in a column-by-column manner and without gaps in order to obtain the permuted information word, and/or
    the third interleaver stage is configured for a row-by-row arranging of row indices of the first rows in third rows and third columns, and for the column-by-column reading of the row indices in order to obtain scrambled row indices, and for interchanging the first rows based on the scrambled row indices, and for interchanging the first rows based on the scrambled row indices, wherein the first interleaver stage is configured for reading the first rows, which are interchanged based on the scrambled row indices, in a column-by-column manner and without gaps in order to obtain the permuted information word.

4.  The interleaver of any one of claims 1 to 3, wherein the second interleaver stage is configured for arranging the digits of the one first row in a number of second rows and a number of second columns, the one first row comprising a number of digits less than the product of the number of second rows and the number of second columns, and wherein the second interleaver stage is further configured for skipping gaps occurring in the column-by-column reading.

5.  The interleaver of any one of claims 1 to 4, wherein the first, second and/or third interleaver stages are configured for processing an information word, wherein each digit includes a binary digit.

6.  The interleaver of any one of claims 1 to 5, wherein the third interleaver stage is configured for arranging the row indices in a number of third rows and a number of third columns, the number of row indices being less than the product of the number of third rows and the number of third columns, and wherein the third interleaver stage is further configured for skipping gaps occurring in the column-by-column reading.

7.  The interleaver of any one of claims 1 to 6, wherein the first, second and/or third interleaver stages are configured for scrambling a vector of read or write addresses as the information word.

8.  A method of scrambling an information word, the information word comprising a plurality of digits, in order to obtain a permuted information word, comprising:

    row-by-row arranging of the digits of the information word in a plurality of first rows and first columns, a last of the first rows being incomplete and having a gap in at least a last of the first columns; and
    scrambling the digits of the first rows including the last row having at least the gap in the last first column by interchanging at least two digits of the respective first row such that in the last first row a position of the gap remains unchanged in order to obtain first scrambled rows;
    replacing the first rows by the first scrambled rows;
    performing inter-row-permutation at the first rows after replacing the same by the scrambled rows;
    reading the first columns after the inter-row-permutation in a column-by-column manner using a calculation regulation, and lining the digits of the first columns up without gaps in order to obtain the permuted information word; and
    using the calculation regulation in order to obtain an address Addr in the permuted information word for a digit in a first row with a column index Ilvd_Col_Idx after scrambling the digits of the first rows and with a row index Ilvd_Row_Idx after inter-row permutation, wherein Short_Row_Idx is the row index of the incomplete first row after inter-row permutation, Num_Rem_Bits is a number of digits in the incomplete row, and Num_Full_Rows is the number of complete first rows, and the calculation regulation is:

    if Ilvd_Col_Idx is smaller than Num_Rem_Bits,
    calculate Addr to be equal to (Num_Full_Rows+1)*Ilvd_Col_Idx + Ilvd_Row_Idx;
    if Ilvd_Col_Idx is not smaller than Num_Rem_Bits, and Ilvd_Row_Idx is smaller than Short_Row_Idx,
    calculate Addr to be equal to (Num_Full_Rows+1)* Num_Rem_Bits + Num_Full_Rows * (Ilvd_Col_Idx-Num_Rem_Bits) + Ilvd_Row_Idx;
    if Ilvd_Col_Idx is not smaller than Num_Rem_Bits, and Ilvd_Row_Idx is not smaller than Short_Row_Idx,
    calculate Addr to be equal to (Num_Full_Rows+1)* Num_Rem_Bits + Num_Full_Rows * (Ilvd_Col_Idx-

Num_Rem_Bits) + Ilvd_Row_Idx.

9. Computer program with a program code for performing one of the methods of claim 8, when the program code is executed on a processor.

10. Turbo encoder or decoder having an interleaver of any one of claims 1 to 7.

**Revendications**

1. Dispositif d'entrelacement pour brouiller un mot d'information, dans lequel le mot d'information présente une pluralité de positions pour obtenir un mot d'information permuté, aux caractéristiques suivantes:

   un premier étage de dispositif d'entrelacement destiné à organiser par rangée les positions du mot d'information dans une pluralité de premières rangées et de premières colonnes, où une dernière des premières rangées est incomplète et présente une lacune au moins dans une dernière des premières colonnes; et
   un deuxième étage de dispositif d'entrelacement destiné à brouiller les positions des premières rangées, y compris la dernière rangée avec au moins la lacune dans la dernière première colonne en permutant au moins deux positions de la première rangée respective, et ce de sorte que reste inchangée dans la dernière première rangée une position de la lacune, pour obtenir des premières rangées brouillées et pour remplacer les premières rangées par les premières rangées brouillées;
   un troisième étage d'entrelacement destiné à effectuer une permutation entre rangées sur les premières rangées après le remplacement de ces dernières par les rangées brouillées;
   dans lequel le premier étage d'entrelacement est conçu pour lire les premières colonnes après la permutation entre rangées par colonne au moyen d'une règle de calcul et pour juxtaposer les positions des premières colonnes sans lacune, pour obtenir le mot d'information permuté,
   dans lequel le dispositif d'entrelacement est conçu pour utiliser la règle de calcul pour obtenir une adresse Addr dans le mot d'information permuté pour un position dans une première rangée avec un indice de colonne Ilvd_Col_Idx après le brouillage des positions des premières rangées et un indice de rangée Ilvd_Row_Idx après la permutation entre rangées, où Short_Row_Idx est l'indice de rangée de la première rangée incomplète après la permutation entre rangées, Num_Rem_Bits est un nombre de positions dans la rangée incomplète et Num_Full_Rows est le nombre de premières rangées complètes, et la règle de calcul est la suivante:

   si Ilvd_Col_Idx est plus petit que Num_Rem_Bits,
   calculer Addr pour (Num_Full_Rows+1) * Ilvd_Col_Idx + Ilvd_Row_Idx;
   si Ilvd_Col_Idx n'est pas plus petit que Num_Rem_Bits et que ilvd_Row_Idx est plus petit que Short_Row_Idx,
   calculer Addr pour (Num_Full_Rows+1) * Num_Rem_Bits + Num_Full_Rows * (Ilvd_Col_Idx-Num_Rem_Bits) + Ilvd_Row_Idx;
   si Ilvd_Col_Idx n'est pas plus petit que Num_Rem_Bits et Ilvd_Row_Idx n'est pas plus petit que Short_Row_Idx,
   calculer Addr pour (Num_Full_Rows + 1) * Num_Rem_Bits + Num_Full_Rows * (Ilvd_Col_Idx-Num_Rem_Bits) + Ilvd_Row_Idx.

2. Dispositif d'entrelacement selon la revendication 1, dans lequel le deuxième étage du dispositif d'entrelacement est configuré pour brouiller les positions de la première rangée par une règle de dispositif d'entrelacement congruente linéairement, de sorte qu'une position de la lacune reste inchangée, pour obtenir la première rangée brouillée, et pour remplacer l'une des premières rangées par la première rangée brouillée.

3. Dispositif d'entrelacement selon l'une des revendications 1 ou 2, dans lequel
   le deuxième étage de dispositif d'entrelacement est conçu pour organiser par rangée les positions de l'une des premières rangées dans une pluralité de deuxièmes rangées et de deuxièmes colonnes, et pour lire par colonne les positions, pour obtenir une première rangée brouillée et pour remplacer l'une des premières rangées par la première rangée brouillée, où le premier étage de dispositif d'entrelacement est conçu pour lire par colonne et sans lacune, sur base de la première rangée brouillée, la première rangée remplacée, pour obtenir le mot d'information permuté, et/ou
   le troisième étage de dispositif d'entrelacement est conçu pour organiser par rangée les indices de rangée des premières rangées dans des troisièmes rangées et des troisièmes colonnes et pour lire par colonne les indices de rangée, pour obtenir des indices de rangée brouillés et pour permuter les premières rangées sur base des indices de rangée brouillés, où le premier étage de dispositif d'entrelacement est conçu pour lire par colonne et sans lacune, sur base des indices de rangée brouillés, les premières rangées échangées, pour obtenir le mot d'information permuté.

4. Dispositif d'entrelacement selon l'une des revendications 1 à 3, dans lequel le deuxième étage de dispositif d'entrelacement est conçu pour organiser les positions de l'une première rangée dans un nombre de deuxièmes rangées et un nombre de deuxièmes colonnes, dans lequel la première rangée présente un nombre de positions qui est plus petit que le produit du nombre de deuxièmes rangées et du nombre de deuxièmes colonnes, et le deuxième étage de dispositif d'entrelacement est par ailleurs conçu pour sauter les lacunes qui se présentent lors de la lecture par colonne.

5. Dispositif d'entrelacement selon l'une des revendications 1 à 4, dans lequel le premier, le deuxième et/ou le troisième étage de dispositif d'entrelacement sont conçus pour traiter un mot d'information dans lequel chaque position comporte une position binaire.

6. Dispositif d'entrelacement selon l'une des revendications 1 à 5, dans lequel le troisième étage de dispositif d'entrelacement est conçu pour organiser les indices de rangée dans un nombre de troisièmes rangées et un nombre de troisièmes colonnes, où le nombre d'indices de rangée est plus petit que le produit du nombre de troisièmes rangées et du nombre de troisièmes colonnes et le troisième étage de dispositif d'entrelacement est par ailleurs conçu pour sauter les lacunes qui se présentent lors de la lecture par colonne.

7. Dispositif d'entrelacement selon l'une des revendications 1 à 6, dans lequel le premier, le deuxième et/ou le troisième étage de dispositif d'entrelacement sont conçus pour brouiller comme mot d'information un vecteur d'adresses de lecture ou d'écriture.

8. Procédé pour brouiller un mot d'information, dans lequel le mot d'information présente une pluralité de positions, pour obtenir un mot d'information permuté, aux étapes suivantes consistant à organiser par rangée les positions du mot d'information dans une pluralité de premières rangées et de premières colonnes, où une dernière des premières rangées est incomplète et présente une lacune au moins dans une dernière des premières colonnes; et brouiller les positions des premières rangées, y compris la dernière rangée avec au moins la lacune dans la dernière première colonne en permutant au moins deux positions de la première rangée respective, et ce de sorte que dans la dernière première rangée reste inchangée une position de la lacune, pour obtenir des premières rangées brouillées; remplacer les premières rangées par les premières rangées brouillées;

effectuer une permutation entre rangées sur les premières rangées après le remplacement de ces dernières par les rangées brouillées;

lire par colonne les premières colonnes après la permutation entre rangées au moyen d'une règle de calcul et juxtaposer sans lacune les positions des premières colonnes, pour obtenir le mot d'information permuté; et

utiliser la règle de calcul pour obtenir une adresse Addr dans le mot d'information permuté pour un position dans une première rangée avec un indice de colonne Ilvd_Col_Idx après le brouillage des positions des premières rangées et un indice de rangée Ilvd_Row_Idx après la permutation entre rangées, où Short_Row_Idx est l'indice de rangée de la première rangée incomplète après la permutation entre rangées, Num_Rem_Bits est un nombre de positions dans la rangée incomplète et Num_Full_Rows est le nombre de premières rangées complètes, et la règle de calcul est la suivante:

si Ilvd_Col_Idx est plus petit que Num_Rem_Bits,
calculer Addr pour (Num_Full_Rows+1) * Ilvd_Col_Idx + Ilvd_Row_Idx;
si Ilvd_Col_Idx n'est pas plus petit que Num_Rem_Bits et que ilvd_Row_Idx est plus petit que Short_Row_Idx,
calculer Addr pour (Num_Full_Rows+1) * Num_Rem_Bits + Num_Full_Rows * (Ilvd_Col_Idx-Num_Rem_Bits) + Ilvd_Row_Idx;
si Ilvd_Col_Idx n'est pas plus petit que Num_Rem_Bits et Ilvd_Row_Idx n'est pas plus petit que Short_Row_Idx,
calculer Addr pour (Num_Full_Rows + 1) * Num_Rem_Bits + Num_Full_Rows * (Ilvd_Col_Idx-Num_Rem_ Bits) + Ilvd_Row_Idx.

9. Programme d'ordinateur avec un code de programme pour réaliser l'un des procédés selon la revendication 8 lorsque le code de programme est exécuté sur un processeur.

10. Turbo-codeur ou turbo-décodeur avec un dispositif d'entrelacement selon l'une des revendications 1 à 7.

Spalten

| Zeilen | 0 | 1 | 2 | 3 |
|---|---|---|---|---|
| 0 | 0/0 | 3/1 | 6/2 | 8/3 |
| 1 | 1/4 | 4/5 | 7/6 | 9/7 |
| 2 | 2/8 | 5/9 | | |

X/Y: X = Lese-Index, Y = Schreib-Index

# FIGUR 1A

Eingangsindex, Spaltenzahl, Elementzahl
unvollständiger Zeilenindex

Zeilenindex = $\lceil$Eingangsindex / Spaltenzahl$\rceil$
Spaltenindex =
Eingangsindex modulo Spaltenzahl  ~110

Vollzeilenzahl = $\lceil$Elementzahl / Spaltenzahl$\rceil$
Restelementzahl =
Elementzahl modulo Spaltenzahl  ~112

114

Spaltenindex <
Restelementzahl?

Ja | Nein

~116

Ausgangsindex =
(Vollzeilenzahl + 1)·
Spaltenindex + Zeilenindex

118

keine unvollständigen Zeilen
$\vee$
Zeilenindex $\leq$ unvollständiger
Zeilenindex

Ja

Ausgangsindex =
(Vollzeilenzahl + 1) · Restelementzahl + Vollzeilenzahl·
(Spaltenindex - Restelementzahl) + Zeilenindex  ~120

Nein

122~

Ausgangsindex =
(Vollzeilenzahl + 1) - Restelementzahl + Vollzeilenzahl·
(Spaltenindex - Restelementzahl) + Zeilenindex -1

# FIGUR 1B

Fast-Rechteck-Interleaver mit einer Länge von 1146 Bits

FIGUR 2

FIGUR 3

Spalten

| Zeilen | 0 | 1 | 2 | 3 | 4 | 5 | 6 | 7 |
|--------|----|----|----|----|----|----|----|----|
| 0 | 0 | 1 | 2 | 3 | 4 | 5 | 6 | 7 |
| 1 | 8 | 9 | 10 | 11 | 12 | 13 | 14 | 15 |
| 2 | 16 | 17 | 18 | 19 | 20 | 21 | | |

## FIGUR 4

Spalten

| Zeilen | 0 | 1 | 2 |
|--------|---|---|---|
| 0 | 0 | 1 | 2 |
| 1 | 3 | 4 | 5 |
| 2 | 6 | 7 | |

## FIGUR 5

Spalten

| Zeilen | 0 | 1 | 2 | 3 | 4 | 5 | 6 | 7 |
|--------|----|----|----|----|----|----|----|----|
| 0 | 0 | 3 | 6 | 1 | 4 | 7 | 2 | 5 |
| 1 | 8 | 10 | 12 | 14 | 9 | 11 | 13 | 15 |
| 2 | 16 | 18 | 20 | 17 | 19 | 21 | | |

## FIGUR 6

Spalten

| | 0 | 1 |
|---|---|---|
| Zeilen | | |
| 0 | 0 | 1 |
| 1 | 2 | |

## FIGUR 7

Spalten

| Zeilen | 0 | 1 | 2 | 3 | 4 | 5 | 6 | 7 |
|---|---|---|---|---|---|---|---|---|
| 0 | 0 | 3 | 6 | 1 | 4 | 7 | 2 | 5 |
| 1 | 16 | 18 | 20 | 17 | 19 | 21 | | |
| 2 | 8 | 10 | 12 | 14 | 9 | 11 | 13 | 15 |

## FIGUR 8

Ausführungsbeispiel des Interleavers für 1146 Bits

FIGUR 9

FIGUR 10A

Koderate 1/4 - 100 Wortfehler pro Punkt

FIGUR 10B

Koderate 2/3 - 100 Wortfehler pro Punkt

FIGUR 10C

Informationsbits

Systematische Bits

1105

1.Komponenten Kodierer

Paritätsbits der 1.Komponente

Turbo Kode Interleaver

1110

2.Komponenten Kodierer

1115

Paritätsbits der 2.Komponente

Punktierer

Kodebits

1120

1100

# FIGUR 11
## (STAND DER TECHNIK)

**FIGUR 12**
**(STAND DER TECHNIK)**

**FIGUR 13**
(STAND DER TECHNIK)

Zufalls-Interleaver einer Länge von 1146 Bits

FIGUR 14
(STAND DER TECHNIK)

Spalten

| Zeilen | 0 | 1 | 2 | 3 |
|---|---|---|---|---|
| 0 | 0/0 | 3/1 | 6/2 | 9/3 |
| 1 | 1/4 | 4/5 | 7/6 | 10/7 |
| 2 | 2/8 | 5/9 | 8/10 | 11/11 |

X/Y: X = Lese-Index, Y = Schreib-Index

# FIGUR 15
## (STAND DER TECHNIK)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1030455 B1
- US 6304991 B1
- US 6871303 B2

### In der Beschreibung aufgeführte Nicht-Patentliteratur

- **CLAUDE BERROU ; ALAIN GLAVIEUX ; PUNYA THITIMAJSHIMA.** Near Shannon-Limit Error-Correcting Coding and Decoding: Turbo Codes. *Intern. Conf. on Communication,* 1993, 1064-1070
- **TODD K. MOON.** Error Correction Coding. Wiley, 2007
- **MARCO BREILING.** Analysis and Design of Turbo Kode Interleavers. Shaker Verlag, 2002
- **S. CROZIER ; P. GUINAND.** High-performance low memory interleaver banks for turbo-codes. *Proc. of the 54th IEEE Veh. Tech. Conf (VTC'01),* Oktober 2001, 2394-2398
- **JOHAN HOKFELT ; OVE EDFORS ; TORLEIV MASENG.** Interleaver design for turbo codes based on the performance of iterative decoding. *Intern. Conf. on Communications, Communications Theory Mini Conference,* 1999, 93-97
- **SERGIO BENEDETTO ; GUIDO MONTORSI.** Unveiling Turbo Codes: Some Results on Parallel Concatenated Coding Schemes. *IEEE Trans. on Inform. Theory,* 1996, vol. 42 (2), 409-428
- **S. DOLINAR ; D. DIVSALAR.** Weight Distributions for Turbo Codes Using Random and Nonrandom Permutations. *Jet Propulsion Lab, TDA Prog. Rep.,* 1995, vol. 42-122, 56-65
- **S. CROZIER ; P. GUINAND.** High-performance low-memory interleaver banks for turbo-codes. *Proc. Of the 54th IEEE Veh. Tech. Conf (VTC'01),* Oktober 2001, 2394-2398